# EUROPEAN PATENT SPECIFICATION

(11) **EP 1 119 090 B1**
(45) Date of publication and mention of the grant of the patent: **27.07.2005**
(21) Application number: 01109165.9
(22) Date of filing: 19.03.1997
(51) Int. Cl.: H02K 5/26

(54) **Motor drive apparatus**
Motorantrieb
Entrainement par moteur

(30) Priority: 22.04.1996 JP 10056196; 22.04.1996 JP 10056296
(43) Date of publication of application: 25.07.2001
(62) Divisional of application: 97907374.9
(73) Proprietor: Seiko Epson Corporation, Tokyo 163-08 (JP)
(72) Inventor: Kawabata, Seiji c/o Seiko Epson Corporation, Nagano (JP); Soya, Yasushi c/o Seiko Epson Corporation, Nagano (JP); Naktata, Satoshi c/o Seiko Epson Corporation, Nagano (JP)
(74) Representative: Rupprecht, Kay, Dipl.-Ing.

(56) References cited:
- JP-U- 3 001 651

## Description

### TECHNICAL FIELD

The present invention relates to a small motor applied to, for example, a vibrating motor.

### BACKGROUND ART

In recent years, pagers and portable telephones (including personal handyphone systems or PHS) have been widely used. Such apparatuses of the type which vibrate to indicate signal reception and attachments thereof (designed specifically for indicating signal reception) are drawing attention. The construction of such type incorporates a vibrating motor having a weight (eccentric mass) fixed to the rotary shaft of the small motor. When a signal is received, the vibrating motor is driven, causing the weight to rotate eccentrically and produce vibration.

Conventionally, such vibrating motors are mounted onto a substrate with a power supplying circuit by soldering or the like, with two lead wires led from the vibrating motor soldered to their predetermined terminals of the power supplying circuit on the substrate.

Accordingly, the above-described mounting method requires fixing of the vibrating motor and soldering of the lead wires, and the soldering must be done by hand, making it troublesome to carry out and time-consuming. These problems also arise when replacing a once-mounted vibrating motor with another vibrating motor.

The soldering, which is done by hand, may result in incorrect wiring, short circuits, breaking of a wire, or the like, causing the motor to be less reliable.

Due to a reaction force produced by rotation of a rotor of the motor, when it is driven, a force is exerted that tries to rotate the entire motor in the opposite direction with respect to the circuit substrate. When the entire vibrating motor rotates, the two lead wires are twisted and become entangled, causing them to break often. In vibrating motors, rotation of the entire vibrating motor occurs much more frequently than it does in common motors, since the vibrating motor is vibrated by driving it.

Therefore, the mounting of the vibrating motor is troublesome and time-consuming, reducing the reliability of the motor.

Accordingly, an object of the present invention is to provide a highly reliable small motor and motor drive apparatus, wherein mounting can be carried out easily and rotation of the entire motor is prevented from occurring.

Another object of the present invention is to provide a motor drive apparatus which makes it possible to prevent mounting of the small motor to the supporting member when the motor is not properly oriented or positioned.

JP 03 00 1651 U discloses an apparatus comprising the features of the preamble of claim 1.

### DISCLOSURE OF THE INVENTION

The invention is defined by the features of the independent claim. Preferred embodiments are defined in the dependent claims.

### BRIEF DESCRIPTION OF THE DRAWINGS

Fig. 1 is a side elevational view of an embodiment of a motor drive apparatus provided with a small motor in accordance with the present invention, with the small motor shown in an unmounted state.
Fig. 2 is a side elevational view of the embodiment of the motor drive apparatus provided with the small motor in accordance with the present invention, with the small motor shown in a mounted state.
Fig. 3 is a plan view of the motor drive apparatus provided with the small motor in accordance with the present invention, with the small motor shown in the mounted state.
Fig. 4 is a bottom view of the motor drive apparatus provided with the small motor in accordance with the present invention, with the small motor shown in the mounted state.
Fig. 5 is a front elevational view of the motor drive apparatus provided with the small motor in accordance with the present invention, with the small motor shown in the mounted state.
Fig. 6 is a rear elevational view of the motor drive apparatus provided with the small motor in accordance with the present invention, with the small motor shown in the mounted state.
Fig. 7 is a longitudinal section of an embodiment of a small motor in accordance with the present invention.
Fig. 8 is a front view showing the construction of the rear bracket and the portion around the rear bracket of the small motor in accordance with the present invention.
Fig. 9 is a partial enlarged perspective view of the construction of the portion around the bottom of the supporting member.
Fig. 10 is a partial longitudinal section of another embodiment of a small motor in accordance with the present invention.
Fig. 11 is a partial longitudinal section of another embodiment of a small motor in accordance with the present invention.
Fig. 12 is a partial longitudinal section of another embodiment of a small motor in accordance with the present invention.
Fig. 13 is a side elevational view of another embodiment of a motor drive apparatus provided with a small motor in accordance with the present invention, with the small motor shown in an unmounted state.
Fig. 14 is a side elevational view of the embodiment of the motor drive apparatus provided with the small motor in accordance with the present invention, with the small motor shown in a mounted state.
Fig. 15 is a rear view of the motor drive apparatus provided with the small motor in accordance with the present invention, with the small motor shown in the mounted state.
Fig. 16 is a front view showing the construction of the rear bracket and the portion around the rear bracket of the small motor in the motor drive apparatus provided with the small motor in accordance with the present invention.
Fig. 17 is a view taken on line XVII-XVII of Fig. 16.
Fig. 18 is a view taken on line XVIII-XVIII of Fig. 16.
Fig. 19 is a view taken on line IXX-IXX of Fig. 16.
Fig. 20 is a view taken on line XX-XX of Fig. 16.
Fig. 21 is a longitudinal section of an embodiment of a small motor in accordance with the present invention.
Fig. 22 is a rear elevational view of the embodiment of the small motor in accordance with the present invention.
Fig. 23 is a rear elevational view of another embodiment of a small motor in accordance with the present invention.
Fig. 24 is a transverse section of another embodiment of a small motor in accordance with the present invention.
Fig. 25 is a side elevational view of the embodiment of the small motor in accordance with the present invention.
Fig. 26 is a longitudinal section of another embodiment of a small motor in accordance with the present invention.
Fig. 27 is rear view of the embodiment of the small motor in accordance with the present invention.
Fig. 28 is a longitudinal section of another embodiment of a small motor in accordance with the present invention.
Fig. 29 is a rear view of the embodiment of the small motor in accordance with the present invention.
Fig. 30 is a longitudinal section of another embodiment of a small motor in accordance with the present invention.
Fig. 31 is an exploded perspective view of another embodiment of a motor drive apparatus provided with a small motor in accordance with the present invention, with the small motor shown in an unmounted state.
Fig. 32 is an exploded perspective view of another embodiment of a motor drive apparatus provided with a small motor in accordance with the present invention, with the small motor shown in an unmounted state.
Fig. 33 is a partial longitudinal section of another embodiment of a small motor in accordance with the present invention.
Fig. 34 is a transverse section of another embodiment of a small motor in accordance with the present invention.
Fig. 35 is a side elevational view of the embodiment of the small motor in accordance with the present invention.
Fig. 36 is a transverse section of another embodiment of a small motor in accordance with the present invention.
Fig. 37 is an exploded perspective view of another embodiment of a motor drive apparatus provided with a small motor in accordance with the present invention, with the small motor shown in an unmounted state.
Fig. 38 is a perspective view of the embodiment of the motor drive apparatus provided with the small motor in accordance with the present invention, with the small motor shown in a mounted state.
Fig. 39 is an exploded perspective view of the embodiment of the motor drive apparatus provided with the small motor in accordance with the present invention, with the small motor shown in the unmounted state.
Fig. 40 is a perspective view of the embodiment of the motor drive apparatus provided with the small motor in accordance with the present invention, with the small motor shown in the mounted state.
Fig. 41 is an exploded perspective view of another embodiment of a motor drive apparatus provided with a small motor in accordance with the present invention, with the small motor shown in an unmounted state.
Fig. 42 is a perspective view of the embodiment of the motor drive apparatus provided with the small motor in accordance with the present invention, with the small motor shown in a mounted state.
Fig. 43 is an exploded perspective view of another embodiment of a motor drive apparatus provided with a small motor in accordance with the present invention, with the small motor shown in an unmounted state.
Fig. 44 is a perspective view of the embodiment of the motor drive apparatus provided with the small motor in accordance with the present invention, with the small motor shown in a mounted state.
Fig. 45 is an exploded perspective view of another embodiment of a motor drive apparatus provided with a small motor in accordance with the present invention, with the small motor shown in an unmounted state.
Fig. 46 is a perspective view of the embodiment of the motor drive apparatus provided with the small motor in accordance with the present invention, with the small motor shown in a mounted state.
Fig. 47 is an exploded perspective view of another embodiment of a motor drive apparatus provided with a small motor in accordance with the present invention, with the small motor shown in an unmounted state.
Fig. 48 is a perspective view of the embodiment of the motor drive apparatus provided with the small motor in accordance with the present invention, with the small motor shown in a mounted state.
Fig. 49 is an exploded perspective view of another embodiment of a motor drive apparatus provided with a small motor in accordance with the present invention, with the small motor shown in an unmounted state.
Fig. 50 is a perspective view of the embodiment of the motor drive apparatus provided with the small motor in accordance with the present invention, with the small motor shown in an mounted state.
Fig. 51 is an exploded perspective of another embodiment of a motor drive apparatus provided with a small motor in accordance with the present invention, with the small motor shown in an unmounted state.
Fig. 52 is a perspective view of the embodiment of the motor drive apparatus provided with the small motor in accordance with the present invention, with the small motor shown in a mounted state.
Fig. 53 is an exploded perspective view of another embodiment of a motor drive apparatus provided with a small motor in accordance with the present invention, with the small motor shown in a unmounted state.
Fig. 54 is a perspective view of the embodiment of the motor drive apparatus provided with the small motor in accordance with the present invention, with the small motor shown in a mounted state.
Fig. 55 is an exploded perspective view of another embodiment of a motor drive apparatus provided with a small motor in accordance with the present invention, with the small motor shown in an unmounted state.
Fig. 56 is a perspective view of the embodiment of the motor drive apparatus provided with the small motor in accordance with the present invention, with the small motor shown in a mounted state.
Fig. 57 is a front view of an embodiment of a small motor in accordance with the present invention.

### Reference Numerals

- 1A ~ 1M: Motor drive apparatus
- 2A ~ 2W: Small motor
- 25: Weight
- 3: Casing
- 31: Body
- 311: Opening
- 312: Bent portion
- 313: Opening
- 314: Extension portion
- 315, 316: Cut portions
- 317: Rear end face
- 32: Rear bracket
- 321: Notch
- 33: Rear bracket
- 331: Shaft hole
- 332: Flange
- 333: Outer peripherical wall
- 334: Spacer
- 335, 336: Recesses
- 337: Protruding portion
- 34: Bearing
- 4: Stator
- 41: Permanent magnet
- 5: Rotor
- 51: Core
- 52: Excitation coil
- 53: Rotary shaft
- 54: Commutator
- 541: Body
- 542: Head portion
- 543: Tapered face
- 544: Commutator portion
- 6: Plus terminal
- 60: Base
- 603: Gap
- 61: Bent portion
- 62: Contact portion
- 63: Mounting portion
- 64: Contact portion
- 65: Brush
- 66: Base
- 67, 68: Contact portions
- 7: Minus terminal
- 70: Base
- 701: Leaf spring
- 702: Contact
- 703: Gap
- 71: Front end portion
- 72: Bent-over portion
- 73: Bent portion
- 74: Mounting portion
- 75: Brush
- 76: Base
- 77: Contact portion
- 78: Brazed portion
- 79: Brazing material
- 8, 8A ~ 8I: Supporting member
- 80: Motor mounting space
- 81: Bottom
- 811,812: Openings
- 82: Clamping portion
- 821: Guide
- 83: Engager
- 84: Fixing portion
- 85: Engager
- 86: Base
- 87: Reinforcer
- 98: Contact portion
- 881: Groove
- 89: Recess
- 9a: Male connector
- 9b: Female connector
- 9c: Female connector
- 9d: Male connector
- 90: Connector body
- 91,92: Recesses
- 93, 94: Contactors
- 95: Small-diameter portion
- 96: Protruding portion
- 100: Substrate
- 101 ~107: Contactors
- 108: Engager
- 111: Contactor
- 121: Plate member
- 122: Protrusion
- 123 ~ 126: Cut portions
- 127: Curved portion
- 128: Corner
- 131: Cut portion
- 132 ~ 137: Engagers
- 138: Base
- 139: Front end portion
- 141: Curved portion
- 142: Corner
- 143: Recess
- 144: Curved portion
- 145: Corner
- 151: Engager
- 152: Intermediate portion
- 153: Front end portion
- 154: Engager
- 155: Cut portion 161 Elastic portion

### BEST MODE FOR CARRYING OUT THE INVENTION

A description will now be given of preferred embodiments of a small motor and a motor drive apparatus in accordance with the present invention, with reference to the drawings.

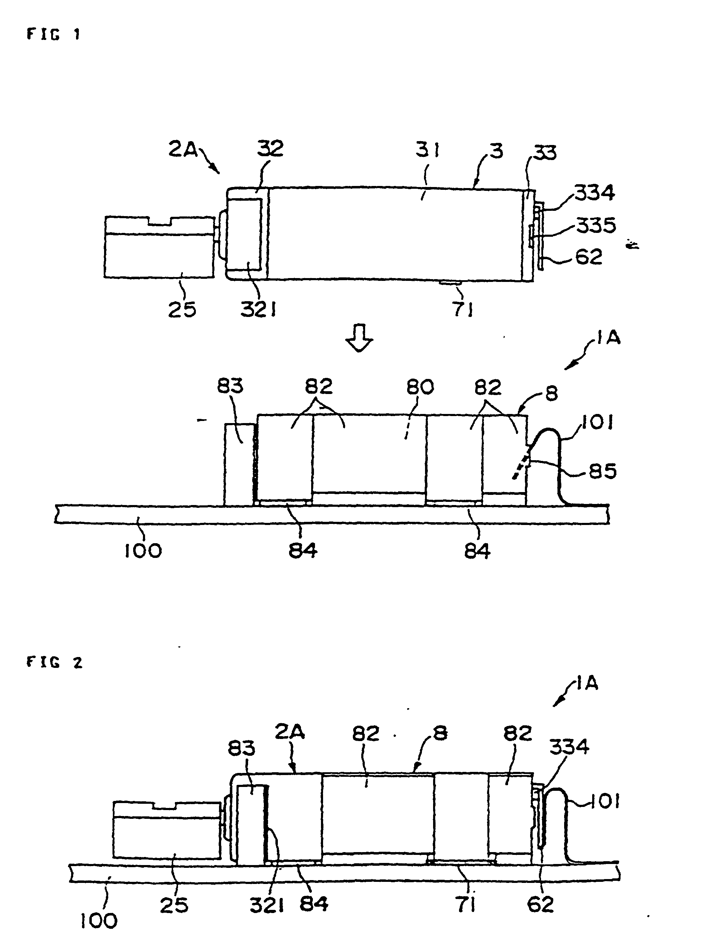

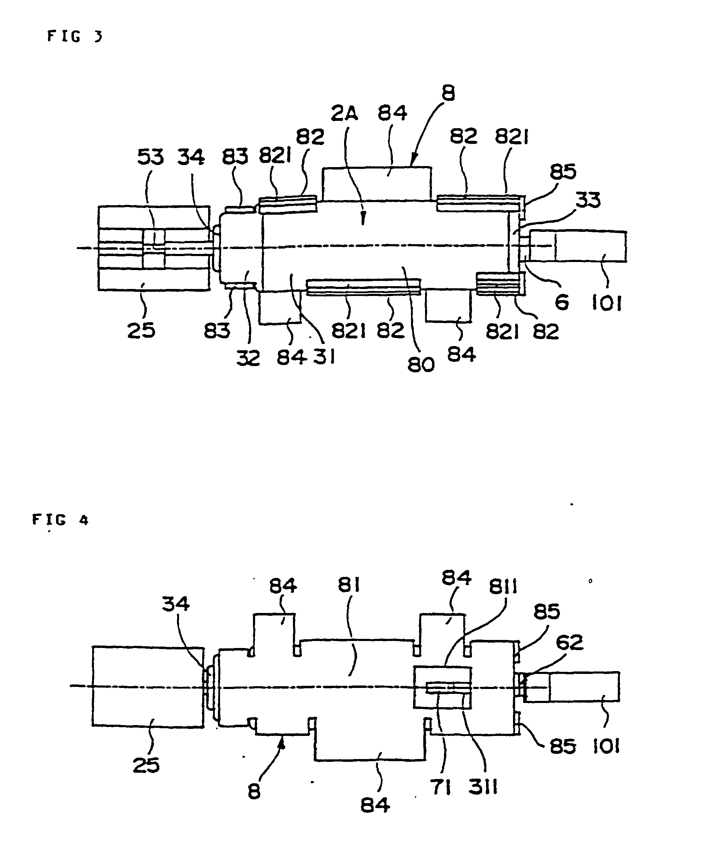

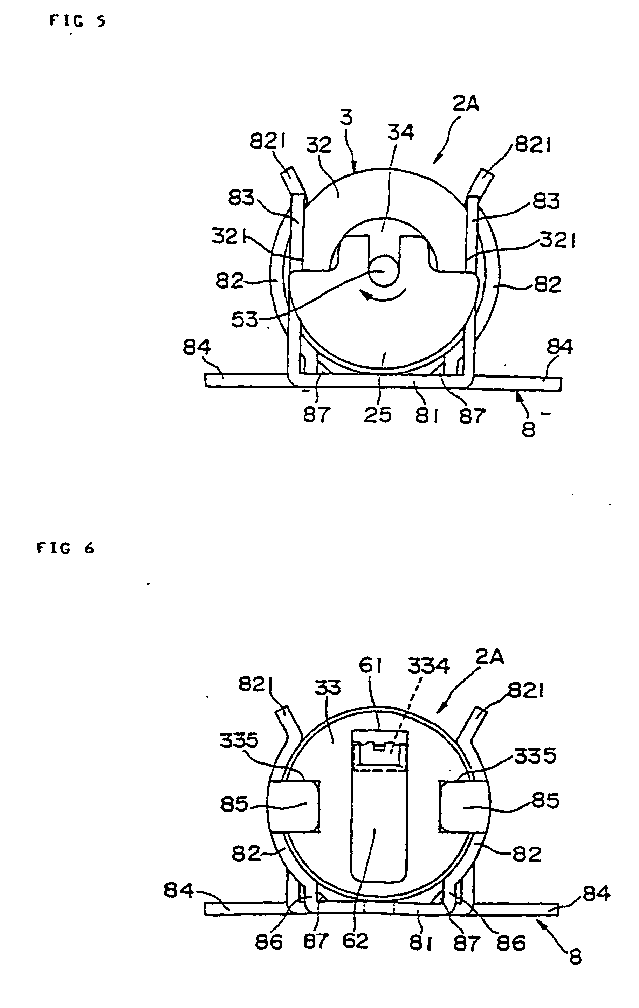

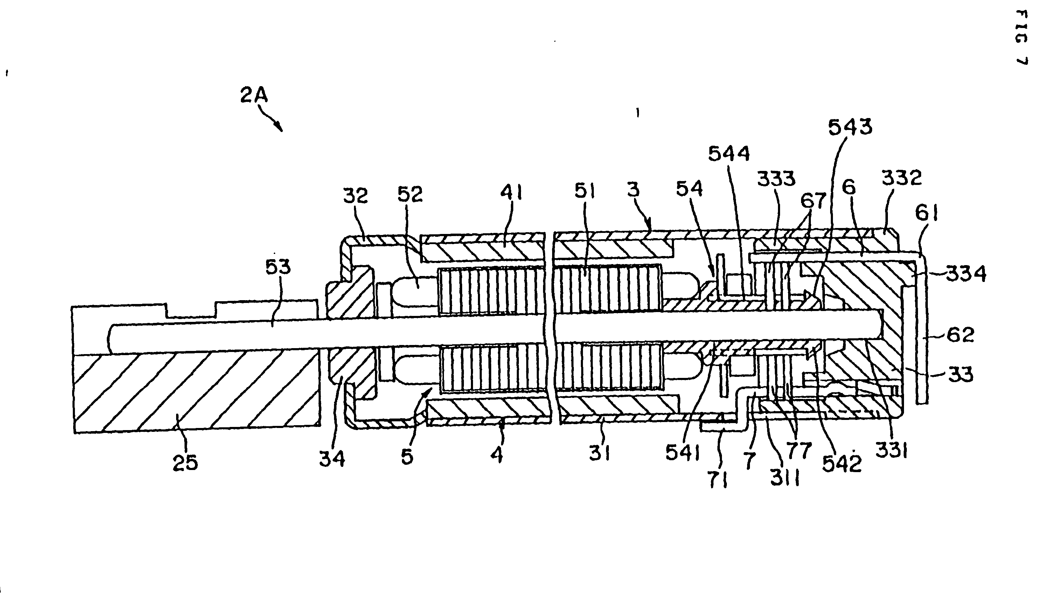

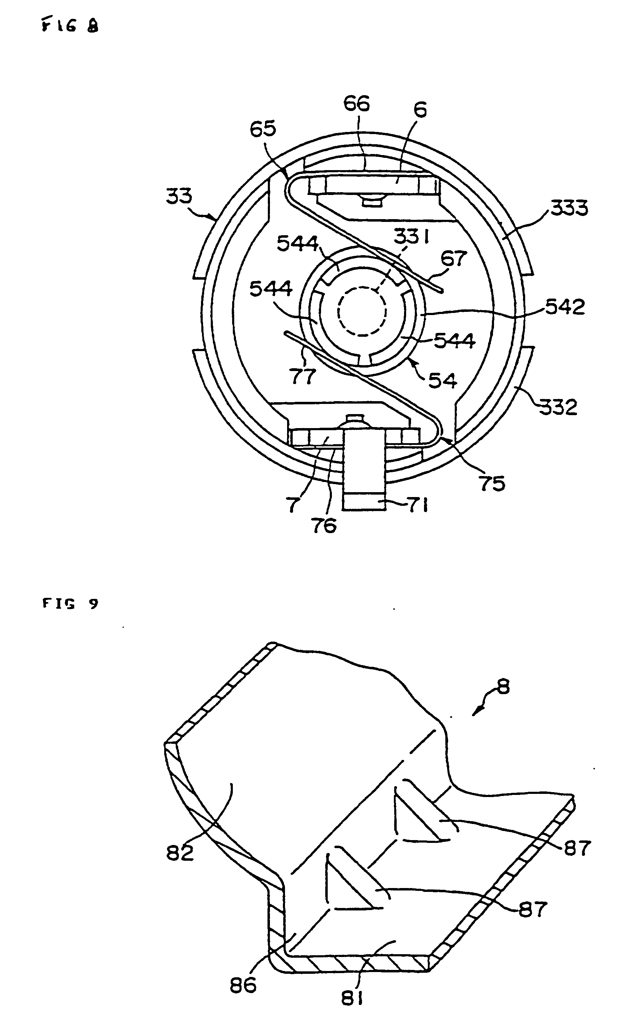

Fig. 1 is a side elevational view of an embodiment of a motor drive apparatus with a small motor in accordance with the present invention, with the small motor in an unmounted state. Fig. 2 is a side elevational view of the motor drive apparatus, with the small motor in a mounted state. Fig. 3 is a plan view of the motor drive apparatus, with the small motor in the mounted state. Fig. 4 is a bottom view of the motor drive apparatus, with the small motor in the mounted state. Fig. 5 is a front elevational view of the motor drive apparatus, with the small motor in the mounted state. Fig. 6 is a rear elevational view of the motor drive apparatus, with the small motor in the mounted state. Fig. 7 is a longitudinal view of an embodiment of a small motor in accordance with the present invention. Fig. 8 is a front view of the rear bracket and the portion therearound in the small motor in accordance with the present invention. Fig. 9 is an enlarged perspective view of the structure around the bottom portion of the supporting member in accordance with the present invention. In Figs. 1 to 4 and Fig. 7, the left side indicates the front end and the right side indicates the back end.

As shown in the figures, the motor drive apparatus 1A of the present invention comprises a substrate 100 having formed thereon a power supplying circuit which is a circuit for supplying electrical power to a small motor 2A, a supporting member 8 which is fixed to the substrate 100, and a small motor 2A which can be mounted to and dismounted from the supporting member 8.

The small motor 2A in the present embodiment is a direct-current vibrating motor and comprises a casing 3, a stator 4 and a rotor 5 contained in the casing 3, a plus terminal (first terminal) 6 for supplying electrical power to the rotor 5 and a minus terminal (second terminal) 7 for supplying electrical power to the rotor 5, and a weight (eccentric mass) 25 fixed to the front end of a rotary shaft 53 of the rotor 5.

The casing 3 includes a cylindrical body 31, a front bracket 32 provided at the front end side of the body 31 (the bracket 32 preferably integrally formed with the body 31), a rear bracket 33 mounted at the rear end side of the body 31, and a bearing 34 fixed to the center portion of the front bracket 32.

The body 31 is composed of conductive metallic material plate, such as an electromagnetic steel plate made of stainless steel, SPCC, SPCE, or the like.

The rear bracket 33 of Figs. 7 and 8 is made of insulating materials such as various resinous materials, and has at is center portion a shaft hole 331 forming a bearing for supporting the rear end of the rotary shaft 53 of the rotor 5. In addition, a flange 332 contacting the rear end edge of the body 31 is formed at the rear end of the rear bracket 33, and an outer peripheral wall 333 which is inserted within the body 31 is raised from the front side outer periphery of the rear bracket 33.

Such a rear bracket 33 is preferably composed of lubricant and insulating resinous material, and more preferably of resinous material having a relatively low coefficient of friction and wear resistance. Examples thereof include polythethylene, polypropylene, liquid crystal polymer (LCP), polytetrafluoroethylene, polyphenylene sulfide (PPS), polyamide, polyimide, polyacetal, and polycarbonate.

A pair of rectangular recesses 335 are formed in the rear end surface of the rear bracket 33. The recesses 335, being engaging portions which engage engagers 85 of the supporting member 8 (described below), serve as anti-rotation means for preventing rotation of the entire small motor 2A with respect to the supporting member 8 due to a reaction force produced by rotational driving of the rotor 5.

Flat-faced opposing notches (recesses) 321, formed on both sides of the axial line of the rotary shaft 53, are formed in the outer peripheral face (side face) of the front bracket 32. The notches 321 are engaging portions for engaging engagers 83 of the supporting member 8 (described later), and similarly serve as anti-rotation means for preventing rotation of the entire small motor 2A.

The front bracket 32 is composed of the aforementioned metallic materials, while the bearing 34 is made of the aforementioned insulating materials (or conductive materials).

The stator 4 is composed of a permanent magnet 41 fixed to the inner peripheral face of the body 31. The permanent magnet 41 may be either a multi-polar cylindrical magnet or a segment type magnet.

Magnetic materials of the permanent magnet 41, though not particularly limited, preferably include highly magnetic materials containing a rare earth element and a transition metal, such as SmCo magnet material, and R-Fe-B magnet material (where R is a rare earth element including Y).

Though, the permanent magnet 41 may take any one of the forms of a sintered magnet, a cast magnet, a resin-bonded type magnet, and the like, the resin-bonded type magnet, which has excellent formability, is the preferred form.

The rotor 5 is rotatably provided inwardly of the stator 4. The rotor 5 includes a core 51, an excitation coil 52 formed by a winding wound around the core 51, a rotary shaft 53 fitted into the center of the core 51, and a commutator 54 formed at the rear end of the core 51. The ends of the rotary shaft 53 are inserted, respectively, into the bearing 34 and the shaft hole 331 to thereby rotatably support the rotary shaft 53 in the casing 3.

The rear end face of the rotary shaft 53 curves outward and contacts a small area (point) of the bottom surface of the shaft hole 331. This reduces the friction force during rotation of the rotor 5.

The rotary shaft 53 is preferably composed of material with a high strength and a low coefficient of friction, such as stainless steel (SUS), bearing steel (SUJ), or the like.

The commutator 54 includes a cylindrical body 541 into which is fitted the rotary shaft 53, and three commutator portions 544 set at 120 degree intervals from each other with respect to the body 541 and being insulated from each other. Each of the commutator portions 544 is electrically connected to their corresponding excitation coils 52 for commutation upon every 60 degree rotation of the rotor 5.

The rear end of the body 541 has a head portion 542 formed into a conical trapezoidal shape, More specifically, a tapered face 543 whose outer diameter gradually decreases from front to back is formed at the outer periphery of the head portion 542. During assembly of the small motor 2A, the tapered face of the head portion 542 functions as a guide face for guiding contact portions 67 and 77 of the brushes 65 and 75 and permits the brushes 65 and 75 to be easily and reliably set at the proper positions with respect to the commutator 54.

The plus terminal 6 and the minus terminal 7 are inserted and fixed to the rear bracket 33 in order to supply electrical power to the rotor 5. Although in the present embodiment, the plus terminal 6 is designated the first terminal, while the minus terminal 7 is designated the second terminal, the designations can be reversed.

The plus terminal 6 and the minus terminal 7 are formed by punching out a metallic blank sheet of, for example, stainless steel, copper or a copper alloy, nickel silver, or tinplate into a predetermined shape, and bending the blank sheet with the predetermined shape.

Of the two terminals, the plus terminal 6 is formed by bending the blank sheet (substantially at right angles) into an L-shaped sheet, with the portion extending from the bent portion 61 to the rear end of the terminal 6 (that is a contact portion 62) disposed substantially parallel to the rear end face of the rear bracket 33 and at a predetermined distance therefrom. The contact portion 62 contacts contactor 101, or power-supplying portion (described later), in order to allow electrical current flow. The contact portion 62 may take the form of an elastically deformable spring.

A spacer 334 projects out from the region near the bent portion 61 formed at the rear end face of the rear bracket 33, and maintains a predetermined interval between the rear end face of the rear bracket 33 and the contact portion 62. When the plus terminal 6 is pushed toward the front end (or a reaction force of the contactor 101 is exerted thereto), the spacer 334 prevents the plus terminal 6 from moving in the same direction the terminal 6 is pushed and become embedded in the rear bracket 33.

The plus terminal 6 is electrically insulated from the minus terminal 7 and the body 31, since the rear bracket 33 has insulating properties.

On the other hand, the minus terminal 7 has a crank-shaped bent portion, the front end 71 of which passes through an opening 311 in the body 31 and out the casing 3. The front end 71 is fixed to the body 31 preferably by welding or brazing (soldering), whereby the minus terminal 7 and the body 31 are electrically connected.

A brush 65, formed from a metallic blank sheet of, for example, copper or a copper alloy, is fixed at its base portion 66 to the plus terminal 6 by, for example, brazing (soldering) to allow passage of current. A contact portion 67 with a small width is formed at one end of the brush 65, and contacts a side face of the commutator 54 with a predetermined pressure due to its elasticity.

Similarly, a brush 75 is fixed at its base 76 by, for example, brazing (soldering) to the minus terminal 7 to allow passage of current. A contact portion 77 with a small width is formed at one end of the brush 75, and contacts a side face of the commutator 54 with a predetermined pressure due to its elasticity.

The brushes 65 and 75 are disposed such that the contact portions 67 and 77 oppose each other, with the commutator 54 interposed therebetween, and symmetrical to the center of rotation of the commutator 54 (Fig. 8). More specifically, the contact portions 67 and 77, being spaced apart by an angle of rotation of 180 degrees, contact the outer periphery of the commutator 54.

Accordingly, when direct current flows through both of the brushes 65 and 75 via the terminals 6 and 7, each of the excitation coils 52 is excited, causing rotation of the rotor 5 in a predetermined direction. This results in commutator 54 reaction, whereby rotation of the rotor 5 is continued as a result of commutation upon every 60 degree rotation.

As shown in Fig. 5, the weight (eccentric mass) 25 is a substantially semi-circular shaped member in longitudinal cross section, with its center of gravity located away from the axial line of the rotary shaft 53. The weight 25 rotates eccentrically as a result of the rotation of the rotor 5, causing vibration.

The weight 25 is preferably composed of metallic material with a relatively high specific gravity, such as tungsten or tungsten alloys including tungsten-copper alloys.

Though not particularly limited, the weight 25, when used in such a vibration motor of the present embodiment, preferably has a specific gravity of about 10 to 20 g/cm³, and more preferably about 17 to 20 g/cm³.

Though the dimensions of the component parts of such a small motor 2A are not particularly limited, the casing 3, when used in the vibrating motor of the present embodiment, has the following dimensions.

The overall length of the casing 3 is preferably about 10 to 20 mm, and more preferably about 10 to 15 mm. The outer diameter of the casing 3 is preferably about 3 to 10 mm, and, more preferably, about 3 to 6 mm.

As shown in Figs. 1 to 6, the supporting member 8 is a member which removably supports the small motor 2A. The supporting member 8 includes a bottom 81, a plurality of plate-shaped clamping portions 82, spaced apart by a motor mounting space 80, are raised from the bottom 81, a pair of engagers 83 similarly raised at the front end of the supporting member 8 from the bottom 81, and fixing portions 84 for fixing the supporting member 8 to the substrate 8, which are preferably integrally formed with each other. More specifically, the supporting member 8 is produced by punching out a metallic blank sheet made of the same material as those, for example, of the body 31 into a predetermined shaped and bending the blank sheet with the predetermined shape.

As shown in Fig. 4, an opening 811, being a clearance which allows the front end 71 of the minus terminal 7 to project exteriorly of the casing 3, when the small motor 2A has been mounted, is formed in a predetermined location in the bottom 81 of the supporting member 8.

Each of the clamping portions 82 is elastically deformable, and is formed into an arcuate shape in correspondence with the curved shape of the outer peripheral face of the casing 3. This allows the small motor 2A to be reliably clamped (held) by the supporting member 8, thereby effectively preventing positional shifting and removal of the small motor 2A caused by vibration produced when the small motor 2A is operated. All or some of the clamping portions 82 clamp the small motor 2A such that they contact the body 31, whereby the body 31 and the supporting member 8 are electrically connected, when the small motor 2A is mounted to the supporting member 8. More specifically, the clamping portions 82 which contact the body 31 form a power supplying portion.

As shown in Figs. 5 and 6, the upper ends of each of the clamping portions 82 are formed into guides 821, and are bent obliquely upward and outward from the motor mounting space 80. They serve as guides for placing the small motor 2A into the motor mounting space 80 provided in the supporting member 8. More specifically, when the small motor 2A is being mounted, the outer peripheral face of the casing 3 contacts with and slides along the guides 821, so that the clamping portions 82 are pressed outward by the casing 3 being mounted, as a result of which the small motor 2A is easily and reliably inserted into the motor mounting space 80.

As shown in Fig. 9, reinforcers (reinforcing means) 87 are provided at the base (around the bottom 81) of each of the clamping portions 82. When the clamping portions 82 are deformed as the small motor 2A is being mounted, the stress is concentrated at the base 86. The reinforcers 87 prevent plastic deformation of the base 86 caused by mounting of the small motor 2A, so that even when mounting and dismounting of the small motor 2A are repeated, the clamping portions 82 retain sufficient clamping force to clamp the small motor 2A.

The reinforcers 87 can be formed in other ways, such as by fixing separate members to the base 86 by welding, brazing, or the like, or by causing the base 86 itself to undergo plastic deformation. The base 86 can also be reinforced, not only by providing reinforcers 87, but also by making the base 86 itself thicker than the other portions.

Such reinforcers 87 can also be provided at the base of the engagers 83.

The pair of clamping portions 82 disposed at the rear end side of the supporting member 8 each have an engager 85 formed by bending a portion of each clamping portion 82 substantially at right angles toward the center of the motor mounting space 80. When the small motor 2A is mounted, the engagers 85 engage the recesses 335 in the rear end of the motor 2A to prevent rotation of the small motor 2A with respect to the supporting member 8.

The pair of engagers 83 formed at the front end side of the supporting member 8 extend substantially perpendicular to the bottom 81. When the small motor 2A is mounted, the engagers 83 engage the recesses 321 in the front end of the small motor 2A for clamping the small motor 2A, whereby the small motor 2A is prevented from rotating with respect to the supporting member 8.

The engagers 83 and 85 serve as anti-rotation means, as well as positioning means for positioning of the small motor 2A in the axial direction thereof (in the horizontal direction).

The supporting member 8 is fixed at each fixing portion 84 extending horizontally from the bottom 81 to the substrate 100 preferably by brazing (soldering), such that the supporting member 8 is brought into conduction with ground (or minus terminal side) in an power supplying circuit (not shown) formed on the substrate 100. This causes the minus terminal 7 of the small motor 2A to be connected to ground of the power supplying circuit on the substrate via the body 31 of the casing 3 and the supporting member 8 which supports the body 31.

A contactor (power supplying portion) 101, being a metallic leaf spring curved into a U shape, is provided at the rear end of the supporting member 8 on the substrate 100. The contactor 101 is connected to the plus side of the power supplying circuit on the substrate 100. When the small motor 2A is mounted to the supporting member 8, a contactor 62 of the plus terminal 6 at the rear end of the small motor 2A contacts the contactor 101 to achieve electrical conduction. Therefore, the plus terminal 6 of the small motor 2A is connected to the plus side of the power supplying circuit on the substrate 100 via the contactor 101.

By virtue of such a construction, when the small motor 2A is mounted to the supporting member 8, it is supported by and fixed to the supporting member 8, and, at the same time, the plus terminal 6 and the minus terminal 7 are connected to their respective predetermined terminals of the power supplying circuit on the substrate 100, allowing electrical power to be supplied to the small motor 2A.

When the small motor 2A is driven by supplying power to it, the applied voltage to the small motor 2A, though not particularly limited, is preferably about 0.8 to 3 V, and more preferably about 1.0 to 1.5 V.

In the small motor 2A and the motor drive apparatus 1A having the above-described constructions, unlike the small motor 2E, the small motor can be mounted to the supporting member 8 with the top and bottom sides (in Fig. 1) reversed to facilitate mounting operations accordingly. In addition, an automatic mounting device (automatic assembly device) may also be used for mounting the small motor.

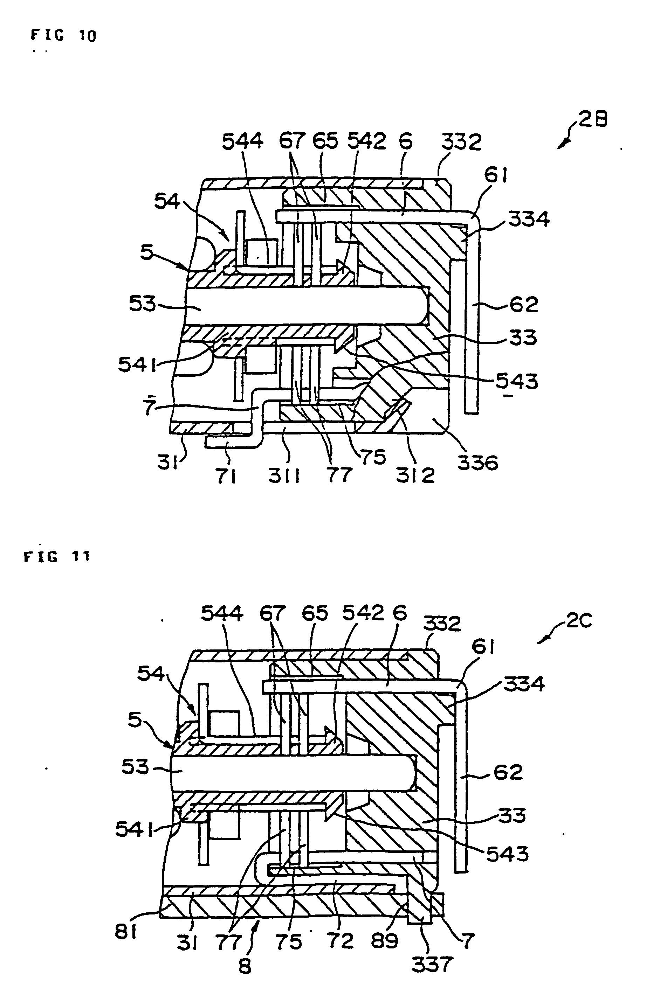

Figs. 10, 11, and 12 are longitudinal sections showing other embodiments of the small motor of the present invention. A description will hereunder be given of these embodiments, in which the same descriptions as those of the previous embodiment are omitted. For description purposes, in Figs. 10 to 12, the left side indicates the front end, while the right side indicates the rear end.

The small motor 2B of Fig. 10 differs from the small motor 2A in that its rear end structure differs from that of the small motor 2A. More specifically, a recess 336 is formed in a portion of the rear bracket 33. In addition, a bent portion 312 is formed by inwardly bending a portion of the outer periphery of the rear end of the body 31. The rear bracket 33 is fixed to the body 31 by the bent portion 312 by caulking.

In such a structure, when the small motor 2B is being produced, the bent portion 312 is formed to perform caulking after insertion of the rear bracket 33 into the body 31, thus allowing the assembly to be performed easily and reliably.

In the small motor 2B, the recess 336 can serve as anti-rotation means (engaging portion) for preventing the small motor 2B from rotating with respect to the supporting member 8. In this case, for example, an engager such as a protrusion (not shown) is formed for engagement with the recess 336.

The small motor 2C of Fig. 11 differs from the above-described small motor 2A in its rear end structure. More specifically, the minus terminal 7 has at the front end side a bent-over portion 72 formed by bending over the terminal 7 by 180 degrees. The rear end of the bent-over portion 72 is bent at right angles in the direction of the outer periphery of the casing 3. The bent-over portion 72 is clamped between the inner peripheral surface of the body 31 and the outer peripheral surface of the bracket 33.

In addition, a portion (at the lower portion in Fig. 11) of the flange 332 of the rear bracket 33 is formed as a protrusion 337, projecting toward the outer peripheral direction.

A recess (opening) 89 for fitting the protrusion 337 therein is formed in the bottom 81 of the supporting member 8 in correspondence with the location of the protrusion 337. The protrusion 337 and the recess 89 serve as anti-rotation means and engage each other to prevent rotation of the entire small motor 2C with respect to the supporting member 8.

Although in the present embodiment, the protrusion 337 has been described as being formed in the rear bracket 33, it may, for example, be formed by outwardly bending the rear end portion of the body 31, in which case a protrusion which functions essentially in the same way as the protrusion 337. The protrusion may be formed by fixing a separate member to the casing 3.

In the small motor, during the production process, the body 31 and the minus terminal 7 do not have to be welded or brazed together, thereby facilitating assembly. In addition, there is no portion, like the front end 71, which protrudes exteriorly from the surface of the casing 2.

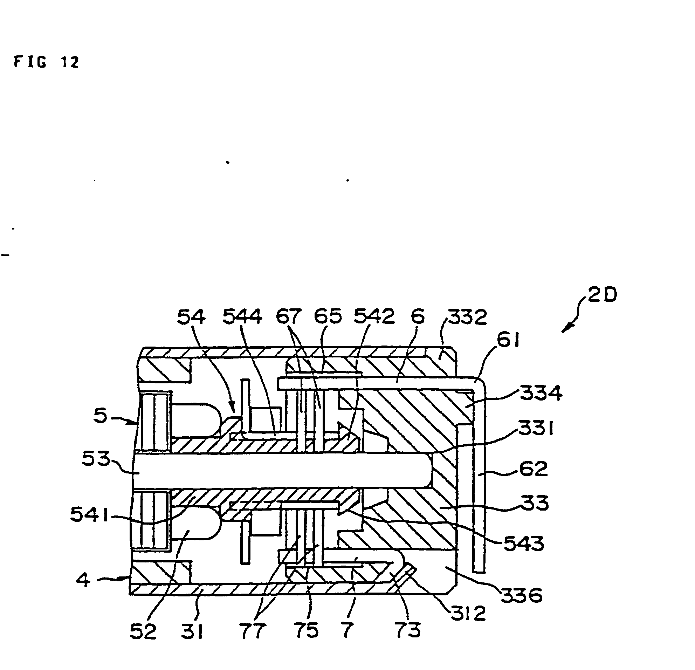

The small motor 2D of Fig. 12 differs from the small motor 2A and 2C in the connecting structure of the minus terminal 7 to the body 31. More specifically, a recess 336 is formed in a portion of the rear bracket 33, and a bent portion 73 is formed at the rear end side of the minus terminal 7 so as to extend in the outer peripheral direction of the casing 3. The bend portion 73 is placed within the recess 336.

On the other hand, a bent portion 312 is formed at the rear end of the body 31 by inwardly bending a portion of the outer periphery thereof. The minus terminal 7 is fixed to the body 31 and the rear bracket 33 by fixing the bent portion 73 of the minus terminal 7 using the bent portion 312 by caulking. In addition, electrical connection is achieved between the minus terminal 7 and the body 31.

In producing the small motor 2D, when the body 31, the rear bracket 33, and the minus terminal 7 are fixed together, the minus terminal 7 and the body 31 are electrically connected at the same time, thus greatly facilitating assembly.

In the small motor 2D, the recess 336 can be used as anti-rotation means (engaging portion) for preventing rotation of the small motor 2D with respect to the supporting member 8. In this case, for example, an engager (not shown), such as a protrusion, is formed in the supporting member 8 for engagement with the recess 336.

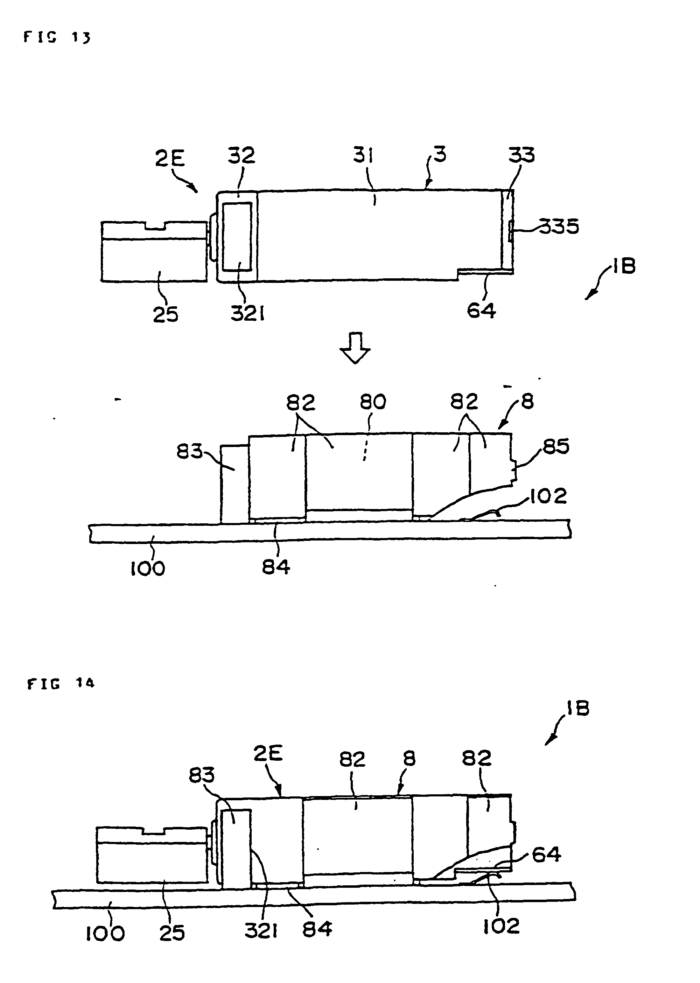

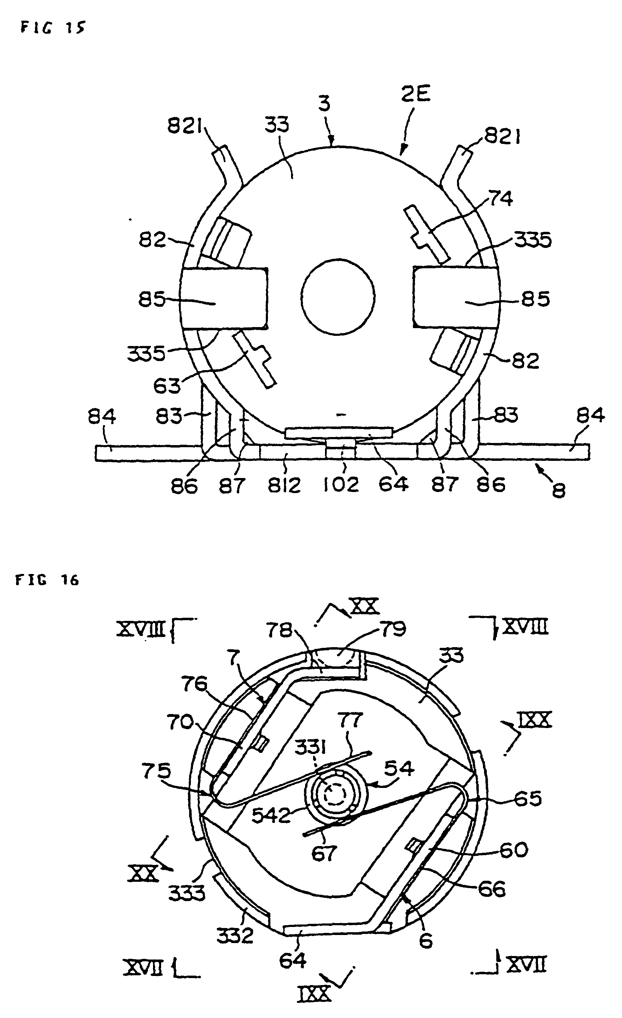

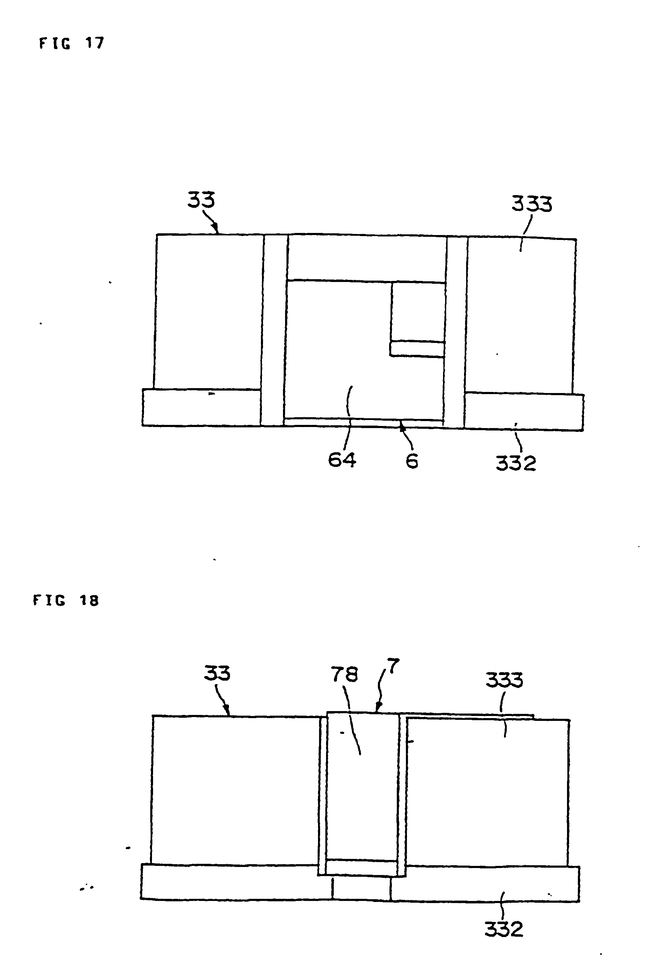

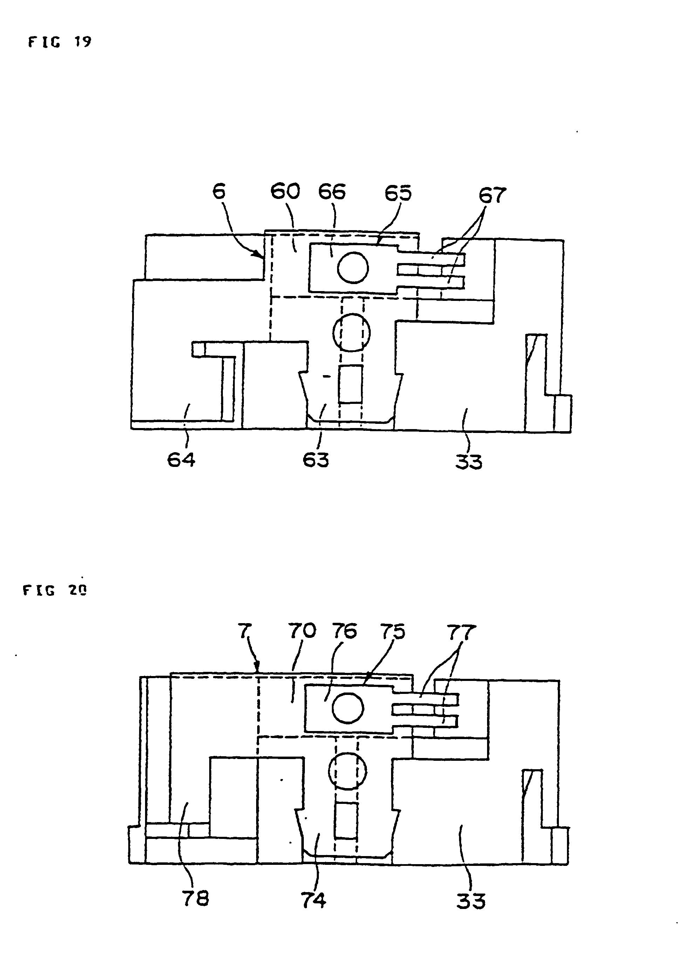

Fig. 13 is a side elevational view of another embodiment of a motor drive apparatus provided with a small motor in accordance with the present invention (with the small motor in an unmounted state). Fig. 14 is a side elevational view the motor drive apparatus (with the small motor in a mounted state). Fig. 15 is a rear view of the motor drive apparatus (with the small motor in the mounted state). Fig. 16 is a front view of the construction of the rear bracket and the region therearound in the small motor of the motor drive apparatus. Fig. 17 is a view taken along line XVII-XVII of Fig. 16. Fig. 18 is a view taken along line XVIII-XVIII of Fig. 16. Fig. 19 is a view taken along line IXX-IXX of Fig. 16. Fig. 20 is a view taken along line XX-XX of Fig. 16.

A description will now be given of the embodiment, with the same descriptions as those of the previous embodiments being omitted. For description purposes, in Figs. 13 and 14, the left side indicates the front end, while the right side indicates the rear end. In Figs. 17 to 20, the top side indicates the front end, while the bottom side indicates the rear end.

As shown in the figures, the motor drive apparatus 1B of the present invention comprises a substrate 100, similar to the previously described substrate 100, having formed thereon a power supply circuit for supplying electrical power to the small motor 2E; a supporting member 8, similar to the aforementioned supporting member 8, fixed to the substrate 100; and a small motor 2E which can be mounted to and dismounted from the supporting member 8.

The small motor 2E of the present embodiment is a direct-current vibrating motor and includes a casing 3, a stator 4, a rotor 5, a power supplying plus terminal 6, a power supplying minus terminal 7, and a weight (eccentric mass) 25, all of which are similar to those of the foregoing description.

The casing 3 includes a metallic (conductive) body 31, a front bracket 32 and a rear bracket 33 mounted to both ends of the body 31, and a bearing 34 fixed to the center of the front bracket 32.

As shown in Figs. 16 to 20, the plus terminal 6 and the minus terminal 7 are fixed to the rear bracket 33 to supply electrical power to the rotor 5. The plus terminal 6 and the minus terminal 7 are formed by punching out a metallic blank sheet into a predetermined shape and bending the sheet with the predetermined shape in the desired manner.

The plus terminal has a base 60, a mounting portion 63 extending rearward from the base 60, a tabular contact portion 64 formed by obliquely bending a portion of the terminal 6 to a predetermined angle (about 110 to 135° in the present embodiment) with respect to the substrate 60.

The plus terminal 6 is fixed at the mounting portion 63 to the rear bracket 33. The substrate 63 is fixed to a brush 65 similar to the one described above.

The contact portion 64 is exteriorly disposed around the outer peripheral surface (side surface) of the rear bracket 33, and contacts a contactor (power supplying portion to be described later) 102 to achieve electrical conduction. The contact portion 64 may take the form of an elastically deformable spring.

On the other hand, the minus terminal 7 has a base 70, a mounting portion 74 extending rearward from the base 70, and a tabular brazed portion 78 formed by obliquely bending a portion of the terminal 7 to a predetermined angle (about 110 to 135° in the present embodiment) with respect to the substrate 70.

The minus terminal 7 is fixed at the mounting portion 74 to the rear bracket 33. The base 70 is fixed to a brush 75 similar to the one described above.

The brazed portion 78 is disposed around the outer peripheral surface (side face) of the rear bracket 33. The brazed portion 78 is formed by brazing to the rear end of the metallic body 31 with brazing material (solder) in order to be electrically connected therewith.

The supporting member 8 of the motor drive apparatus 1B is fixed at each fixing portion 84, preferably by brazing (soldering), to the substrate 100 so as to be in electrical conduction with ground (minus terminal side) in the power supplying circuit formed on the substrate 100. This causes the minus terminal 7 of the small motor 2E to be connected to the ground in the power supplying circuit on the substrate 100 through the body 31 of the casing 3 and the supporting member 8 which supports the body 31.

A contactor (power supplying portion) 102, taking the form of a metallic leaf spring curved into a desired manner, is disposed around the rear end of the supporting member 8 on the substrate 100. The contactor 102 is connected to the plus side of the power supplying circuit on the substrate 100. The contactor 102 passes through an opening 812 in the rear end of the bottom 81 of the supporting member 8 and curves the motor mounting space 80.

When the small motor 2E is mounted to the supporting member 8, the contact portion 64 of the plus terminal 6, which is disposed at the rearward outer peripheral face of the small motor 2E, contacts the contactor 102 to achieve electrical conduction. Accordingly, the plus terminal 6 of the small motor 2E is connected to the plus side of the power supplying circuit on the substrate 100 through the contactor 102.

By virtue of such a construction, when the small motor 2E is mounted to the supporting member 8, it is supported by and fixed to the supporting member 8, and, at the same time, the plus terminal 6 and the minus terminal 7 are connected to their predetermined terminals of the power supplying circuit on the substrate 100, thus making it possible to achieve electrical conduction.

As in the foregoing description, the anti-rotation means, namely the notches 321 (recesses) and the engagers (protruding portions) 83, and the recesses 335 at the rear side of the small motor 2E and the engagers (protruding portions) 85, engage each other in order to prevent rotation of the entire small motor 2E, when it is driven, with respect to the supporting member 8.

In the small motor 2E with such a construction, the plus terminal 6 is not disposed exteriorly at the rear end of the casing 6, as with the small motor 2A, but at the side face thereof, so that compared to the small motor 2A, it can have a smaller overall motor length, and be set in a space with a smaller size in the direction of the motor length.

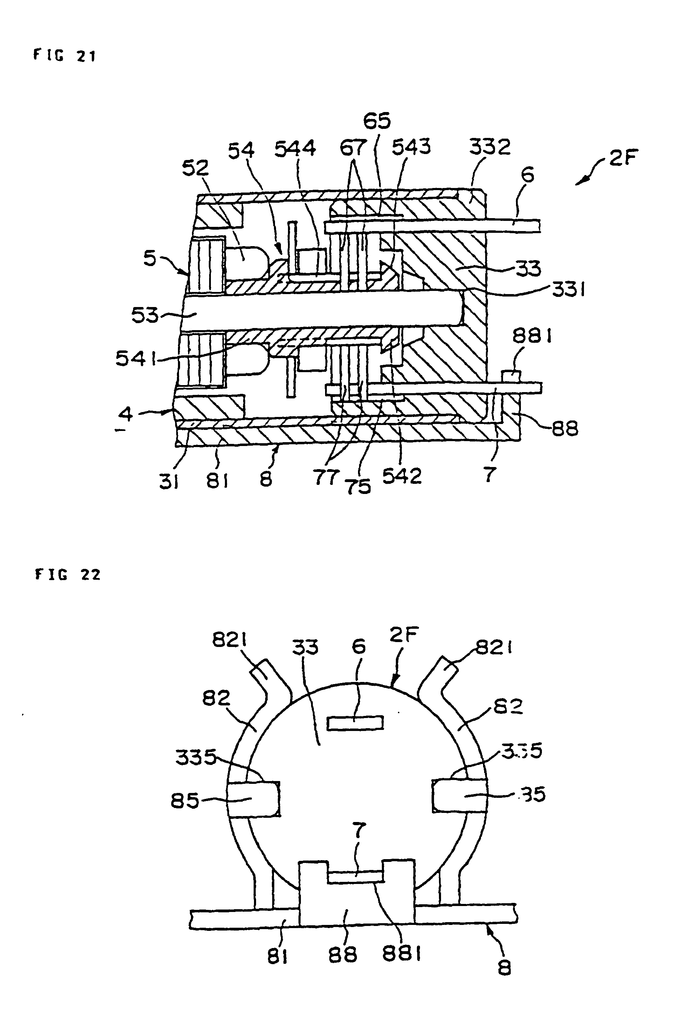

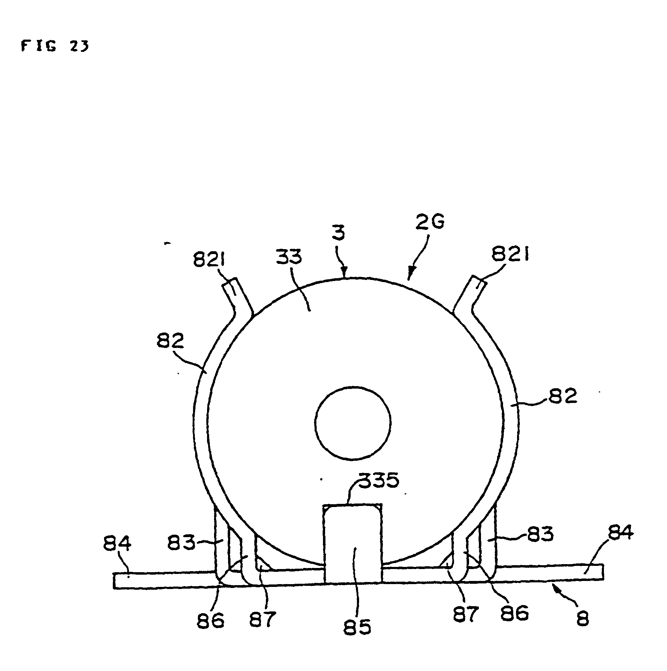

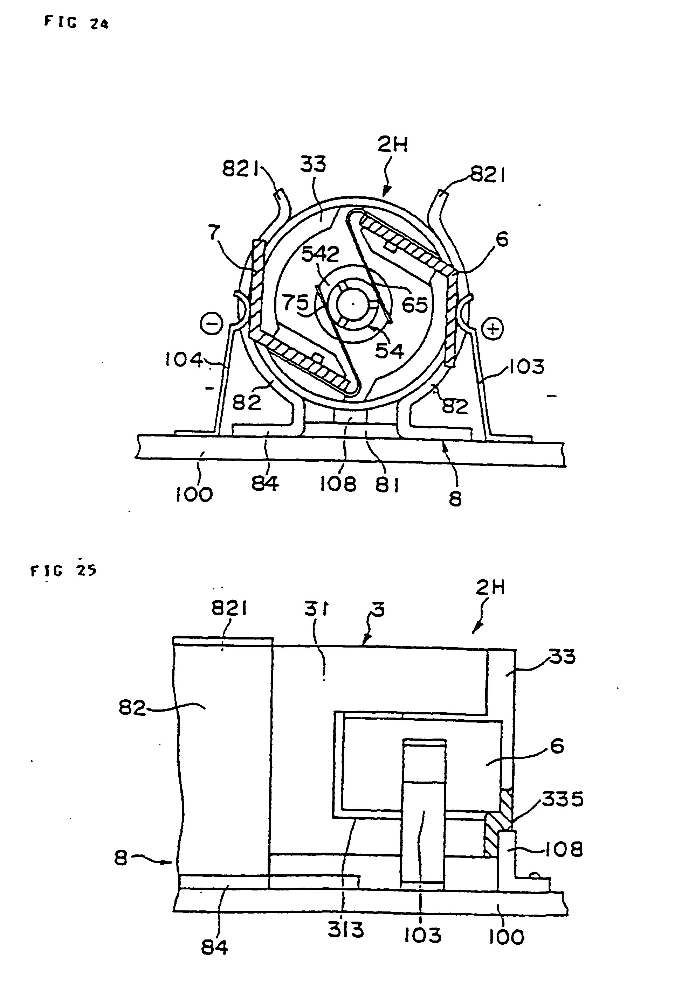

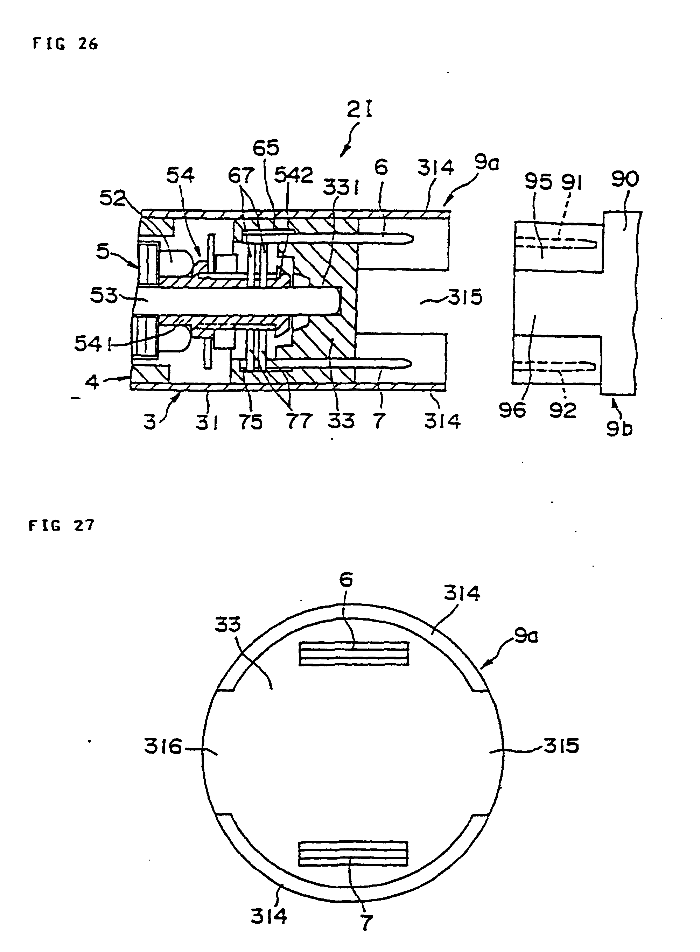

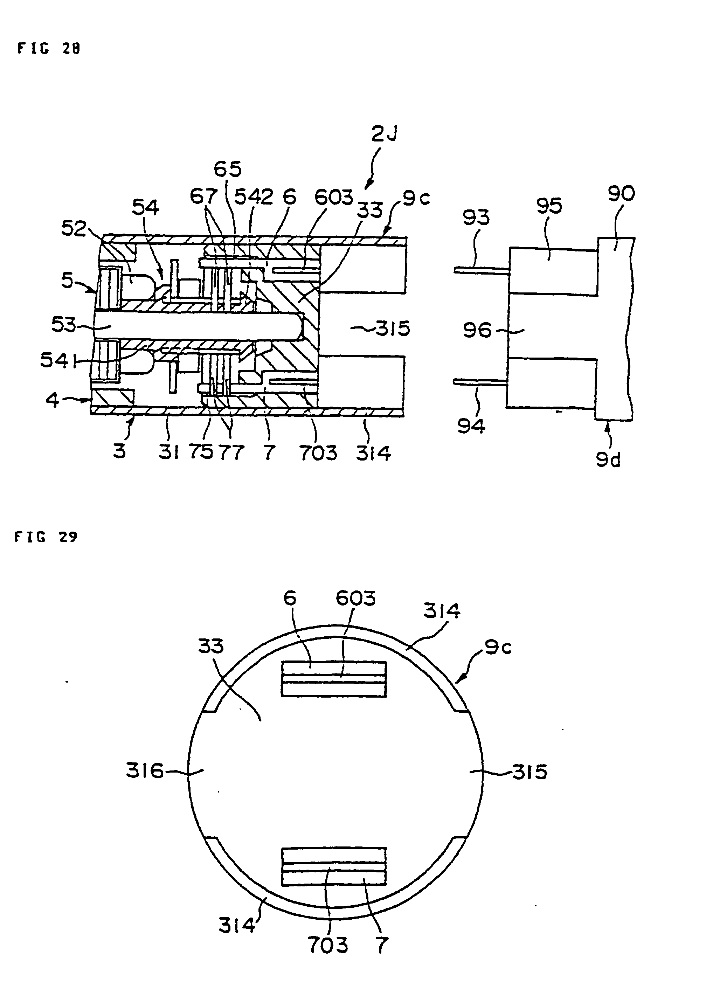

Fig. 21 is a longitudinal section of another embodiment of a small motor in accordance with the present invention. Fig. 22 is a rear view of the small motor. Fig. 23 is a rear view of another embodiment of a small motor in accordance with the present invention. Fig. 24 is a transverse section of another embodiment of a small motor in accordance with the present invention. Fig. 25 is a side elevational view of the small motor. Fig. 26 is a longitudinal section of another embodiment of a small motor in accordance with the present invention. Fig. 27 is a rear view of the small motor. Fig. 28 is a longitudinal section of another embodiment of a small motor in accordance with the present invention. Fig. 29 is a rear view of the small motor.

A description will now be given of the embodiments, with the same descriptions as those of the previous embodiments being omitted. For description purposes, in Figs. 21, 25, 26, and 28, the left side indicates the front end, while the right side indicates the rear end.

The small motor 2F of Figs. 21 and 22 differs from the small motor 2A and the other small motors described above in its rear end construction. More specifically, the plus terminal 6 and the minus terminal 7 protrude from the rear end face of the rear bracket 33 by a predetermined length.

A contactor 88 is raised from the rear end of the bottom 81 of the supporting member 8 by vertically and upwardly bending the rear end portion of the supporting member 8.

When the small motor 2F is mounted to the supporting member 8, a protrusion of the minus terminal 7 fits into a groove (recess) 88 formed in the top portion of the contact portion 88, whereby the minus terminal 7 and the supporting member 8 are brought into electrical conduction. The protrusion of the plus terminal 6 is connected to a terminal (not shown) connected to the plus side of a power supplying circuit on the substrate 100, thus allowing electrical power to be supplied to the small motor 2F.

The small motor G of Fig. 23 is different from the small motor 2A and the other small motors described above in its rear end structure. More specifically, the recess 335 is formed in the lower portion (in Fig. 23) of the rear end face of the rear bracket 33, and the engager (protrusion) 85 which engages the recess 335 is formed in the rear end of the bottom 81 of the supporting member 8. The engager 85 is formed by vertically and upwardly bending the rear end portion of the bottom 81.

The small motor 2H of Figs. 24 and 25 differs from the small motor 2A in its rear end structure. More specifically, a pair of openings 313, formed on both sides of the axial line of the body 31 so as to oppose each other, are formed in the rear end of the body 31, and the plus terminal 6 and the minus terminal 7 are exposed to the outside from the openings 313 along the side face of the casing 3. The recess 335 is formed in the lower portion of the rear end face of the rear bracket 33.

A pair of contactors (power supplying portions) 103 and 104, and an engager (protrusion) 108 are formed vertically on the substrate 100. The contactors 103 and 104 are connected, respectively, to the plus side and the minus side (ground) of the power supplying circuit on the substrate 100.

When the small motor 2H is mounted to the supporting member 8, the contactors 103 and 104 contact the exposed portions of the plus terminal 6 and the minus terminal 7 to permit electrical conduction and thus supply of electrical power. The engager 108 engages the recess 335 to prevent rotation of the entire small motor 2H with respect to the supporting member 8.

The small motor 2I of Figs. 26 and 27 differs from the small motor 2A and the other small motors described above in its rear end structure. More specifically, the body 31 of the casing 3 extends rearward beyond the rear end of the rear bracket 33. A pair of notches (recesses) 315 and 316 are formed in the extension portion 314 extending beyond the rear end so as to oppose each other on both sides of the axial line of the body 31.

The plus terminal 6 and the minus terminal 7 protrude rearward beyond the rear end face of the rear bracket 33 by a predetermined length. In this case, the plus terminal 6 and the minus terminal 7 protrude by substantially the same amount, with the rear ends of the terminals located closer to the front end of the small motor 2I than the rear end of the extension portions 314. The rear end portions of the plus terminal 6 and the minus terminal 7 taper progressively to a small thickness towards the rear end of the apparatus to permit easy insertion of a female connector 9b (described later) into recesses 91 and 92. Accordingly, a male connector 9a is formed at the rear end portion of the small motor 21.

The female connector 9b forming a power supplying portion has a connector body 90 made of a resinous material such as those mentioned above. Recesses 91 and 92 are formed in the front end portion of the connector body 90 for allowing insertion of the rear ends of the plus terminal 6 and the minus terminal 7, respectively. A contactor (not shown), connected to the plus side of the power supplying circuit, is formed at the inner face of the recess 91, while a contactor (now shown), connected to the minus side (ground) of the power supplying circuit, is formed at the inner face of the recess 92.

When the male connector 9a and the female connector 9b are connected together, the rear ends of the plus terminal 6 and the minus terminal 7 are inserted into the recess 91 and the recess 92, respectively, to contact the contactors disposed therein, whereby electrical conduction is achieved to permit power supply to the small motor 2I.

The front end portion of the female connector 9b, excluding a pair of protrusions 96, has a small diameter. The smaller-diameter portion 95 has an outer diameter which is substantially equal to or slightly smaller than the inner diameter of the extension portion 314. The smaller-diameter portion 95, during connection, is inserted within the inner side of the extension portion 314 of the body 31. Here, both of the protrusions 96 are fitted into their corresponding notches 315 and 316 to prevent rotation of the entire small motor 2I with respect to the female connector 9b resulting from a reaction force produced when the rotor 5 is rotationally driven. More specifically, anti-rotation means are the rear end of the plus terminal 6 and the recess 91, the rear end of the minus terminal 7 and the recess 92, the protrusion 96 and the recesses 315, and the protrusion 96 and the recess 316.

Although in the present embodiment, the notches 315 and 316 have the same size and dimension, the notch 315 may be formed to a shape and dimension which are different from those of the corresponding protrusion 96, and the notch 316 may be formed to a shape and dimension which are different from those of the corresponding protrusion 96, so that during connection of the male connector 9a and the female connector 9b, the connectors 9a and 9b can be fitted together only when the notches 315 and 316 and protrusions 96 are properly combined. Such a construction prevents improper connection of the connectors. Consequently, when the connectors 9a and 9b are being connected, it is possible to prevent connections to a terminal of the wrong polarity (mismatching of the plus and minus terminals).

The small motor 2I can be supported by the aforementioned supporting member 8, or by the female connector 9b. For the latter case, the female connector 9b is a power supplying portion and functions as a supporting member (incorporating positioning means).

The small motor 2J of Figs. 28 and 29 is constructed in the same way as the above-described small motor 2I, except for the connector structure. More specifically, an extension portion 314 and notches 315 and 316 are formed in the rear end of the small motor 2J, as with the small motor 2I.

The plus terminal 6 and the minus terminal 7 each having a portion formed with two opposing plates, with a gap (recess) 603 formed between the opposing plates of the plus terminal 6 and a gap (recess) 703 formed between the opposing plates of the minus terminal 7. In this case, the rear ends of the plus terminal 6 and the minus terminal 7 are disposed around the rear end face of the rear bracket 33. The rear end portion of the small motor 2J has a female connector 9c.

On the other hand, the male connector 9d forming the power supplying portion has a smaller-diameter portion 95, and a connector body 90 with a protrusion 96, as with the previously described small motor 2I. Plate-shaped contactors 93 and 94 protrude out from the front end of the connector 90, so that they can be inserted, respectively, into the gap 603 in the plus terminal and the gap 703 in the minus terminal 7. The contactors 93 and 94 are connected to the plus side and the minus side (ground) of the power supplying circuit, respectively.

When the male connector 9d and the female connector 9c are connected together, the contactors 93 and 94 of the male connector 9d are inserted into the gap 603 of the plus terminal 6 and the gap 703 of the minus terminal 7 in order to contact each other, resulting in electrical conduction to permit power supply to the small motor 2J.

As in the foregoing description, in this case, both of the protrusions 96 are fitted into their respective notches 315 and 316 in order to prevent rotation of the entire small motor 2J with respect to the male connector 9d caused by a reaction force produced due to rotational driving of the rotor 5. More specifically, anti-rotation means are the gap 603 and the contactor 93, the gap 703 and the contactor 93, the protrusion 96 and the notch 315, and the protrusion 96 and the notch 316.

The small motor 2J can be provided with means for preventing improper connection of the connectors, as with the small motor 2I.

The small motor 2J can either be supported by the aforementioned supporting member 8, or by the male connector 9d. In the latter case, the male connector 9d functions as a power supplying portion and as a supporting member.

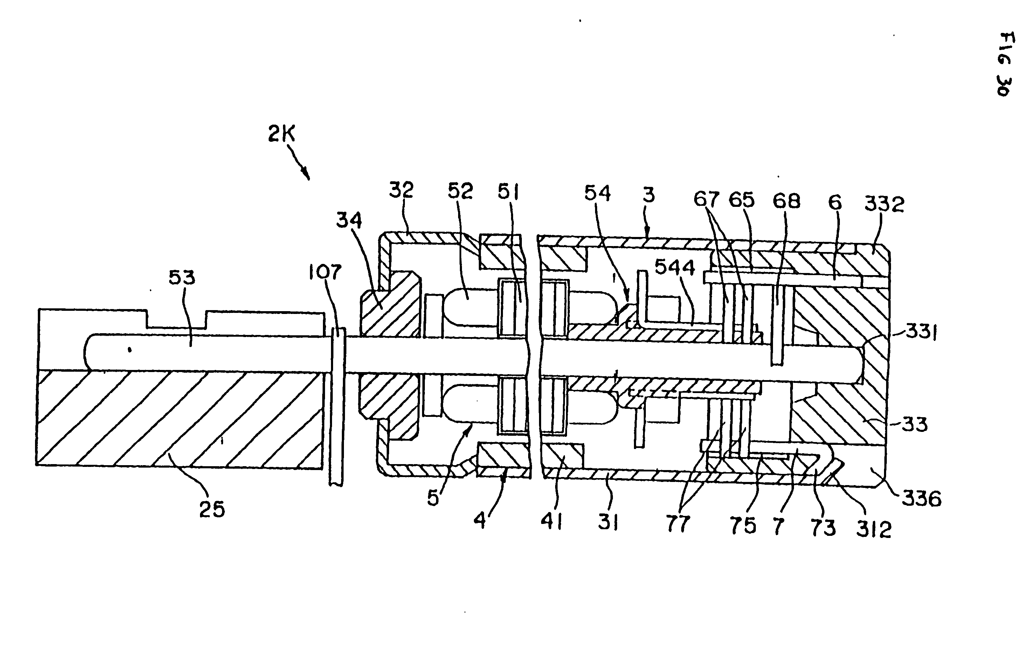

The small motor 2K of the Fig. 30 is one utilizing the rotary shaft 53 as a terminal.

The minus terminal 7 of the small motor 2K has at the rear end side a bent portion 73. As with the small motor 2D, the bent portion 73 is subjected to caulking with the bent portion 312 of the body 31 in order to fix the minus terminal 7 to the body 31 and the rear bracket 33 and electrically connect the minus terminal 7 and the body 31.

The plus terminal 6 is supported by and fixed to the rear bracket 33. In addition to the aforementioned two small width contacting portions 67, the plus terminal 6 has a contactor 68. An end of the contactor 68 contacts the outer peripheral face of the metallic rotary shaft 53 so as to be in electrical conduction with the rotary shaft 53.

The minus terminal 7 and the body 31 are insulated from the plus terminal 6 and the rotary shaft 53 by the rear bracket 33 and the bearing 34 made of insulating materials.

A contactor 107 is formed between the bearing 34 and the weight 25, and contacts the outer peripheral surface of the rotary shaft 53 to achieve electrical conduction. The contactor 107 is formed vertically on the aforementioned substrate 100 and is connected to the plus side of the power supplying circuit on the substrate 100.

A recess 336 in the rear bracket 33 serves as anti-rotation means, as in the foregoing description. For example, an engaging portion, such as a protrusion (not shown) is formed at the supporting member 8 for engagement with the recess 336.

In the small motor 2K with such a construction, with the small motor 2K mounted to the supporting member fixed to the substrate 100, electrical power can be supplied to the small motor 2K through the minus side supporting member 8 and body 31, and the plus side contactor 107 and rotary shaft 53.

In the small motor 2K, it is possible the reverse the polarities. More specifically, it is possible to bring the plus terminal 6 into electrical conduction with the body 31, and to bring the minus terminal 7 into electrical conduction with the rotary shaft 53.

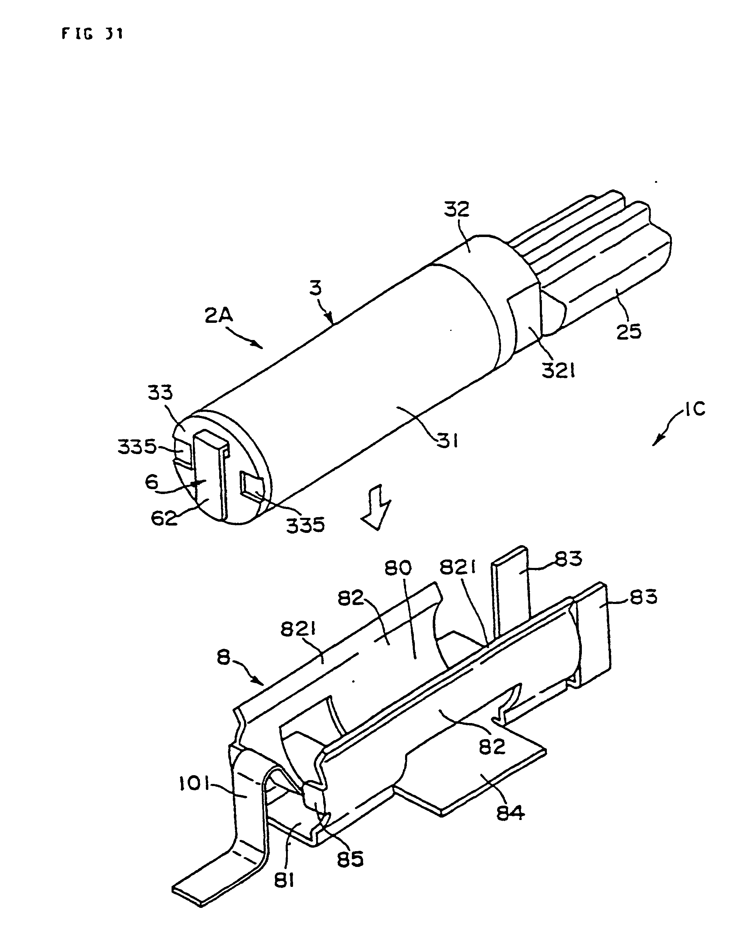

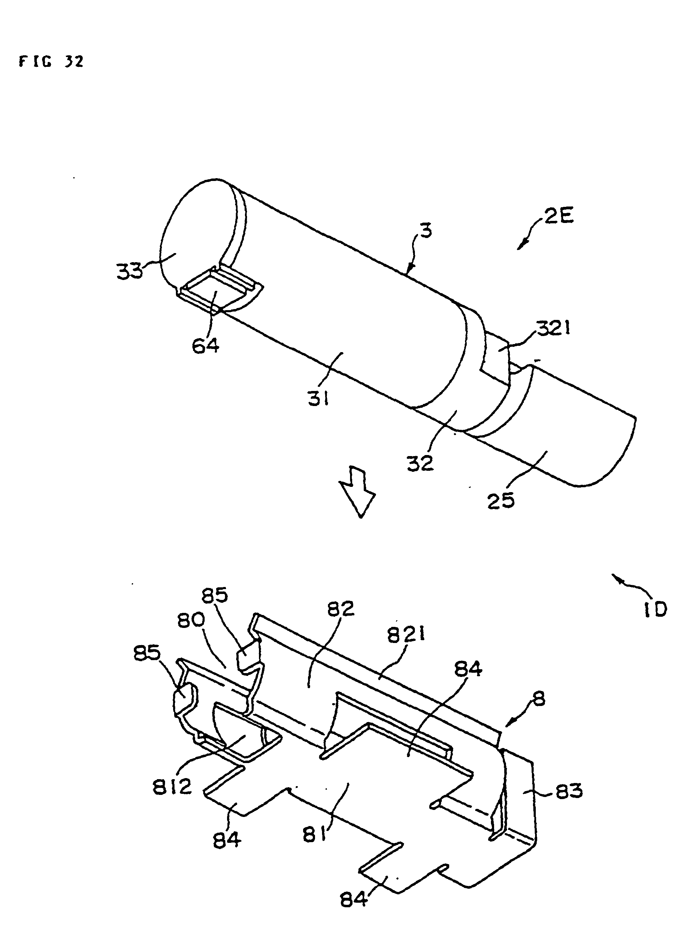

Figs. 31 and 32 are exploded perspective views of other embodiments of a motor drive apparatus with a small motor in accordance with the present invention (with the small motor in an unmounted state). A description will be given of the embodiment illustrated in these figures, with the same descriptions as those of the previous embodiments being omitted.

The motor drive apparatus 1C of Fig. 31 has the same structure as that of the motor drive apparatus 1A, except for the supporting member 8 structure. More specifically, in the supporting member 8 of the motor drive apparatus 1C, a pair of right and left clamping portions 84 oppose each other, with a motor mounting space 80 formed therebetween. In this case, the fixing portions 84 are formed by cutting part of each clamping portion 82.

The motor drive apparatus 1D of Fig. 32 has the same structure as that of the motor drive apparatus 1B, except for the supporting member 8 structure. More specifically, in the supporting member 8 of the motor drive apparatus 1D, a pair of right and left clamping portions 82 oppose each other, with a motor mounting space 80 formed therebetween. In this case, fixing portions 84 are formed by cutting part of each clamping portion 82.

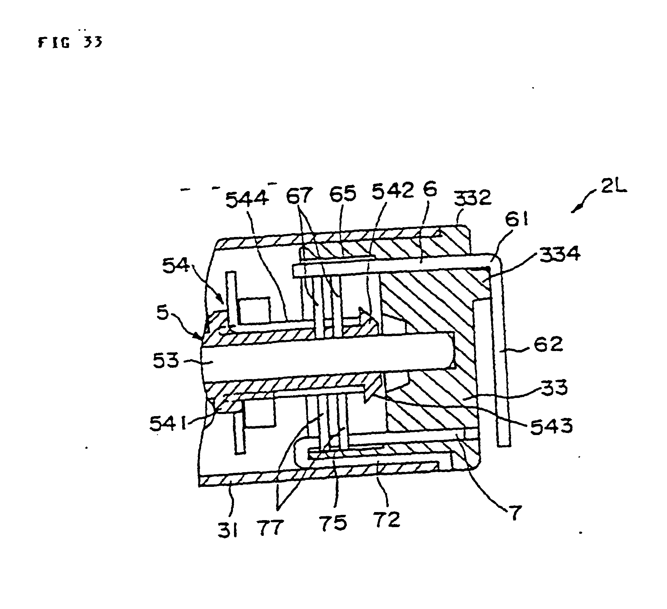

Fig. 33 is a partial longitudinal view of another embodiment of a small motor in accordance with the present invention. A description will hereunder be given of the embodiment, with the same descriptions as those of the previous embodiments being omitted. For description purposes, in Fig. 33, the left side indicates the front end, while the right side indicates the rear end.

The small motor 2L of Fig. 33 differs from the small motor 2A in its structure for connecting the minus terminal 7 to the body 31. More specifically, the minus terminal 7 has at the front end side a bent-over portion 72 formed by bending over part of the terminal 7 by 180 degrees. The rear end of the bent-over portion 72 is bent at right angles towards the outer periphery of the casing 3. The bent-over portion 72 is clamped between the inner peripheral face of the body 31 and the outer peripheral face of the rear bracket 33.

By virtue of such a construction, when the small motor 2L is being produced, it no longer becomes necessary to solder or braze the body 31 and the minus terminal 7, thereby facilitating assembly. In addition, there is no portion which protrudes out from the surface of the casing 2, such as the front end 71.

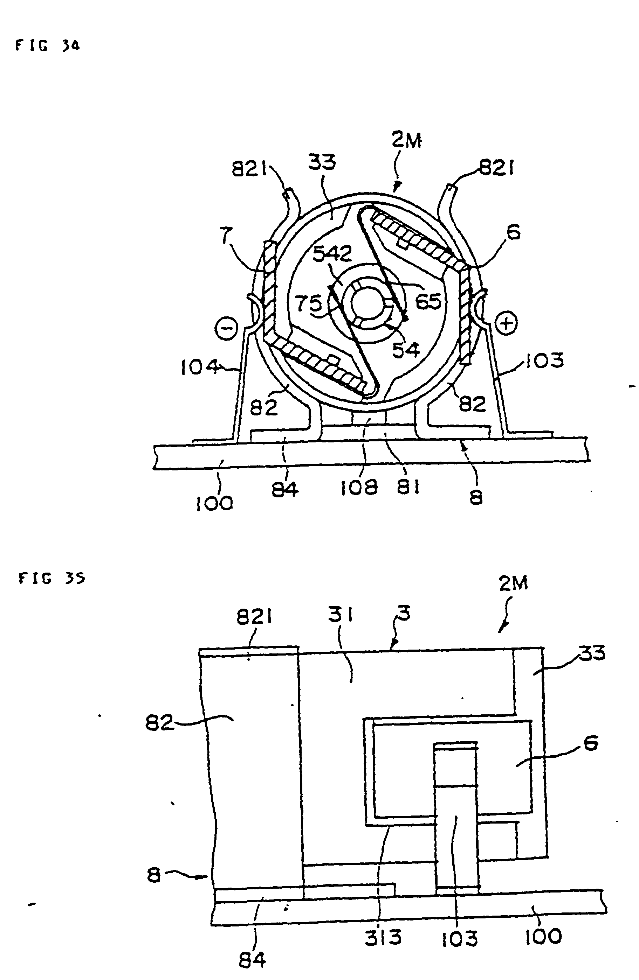

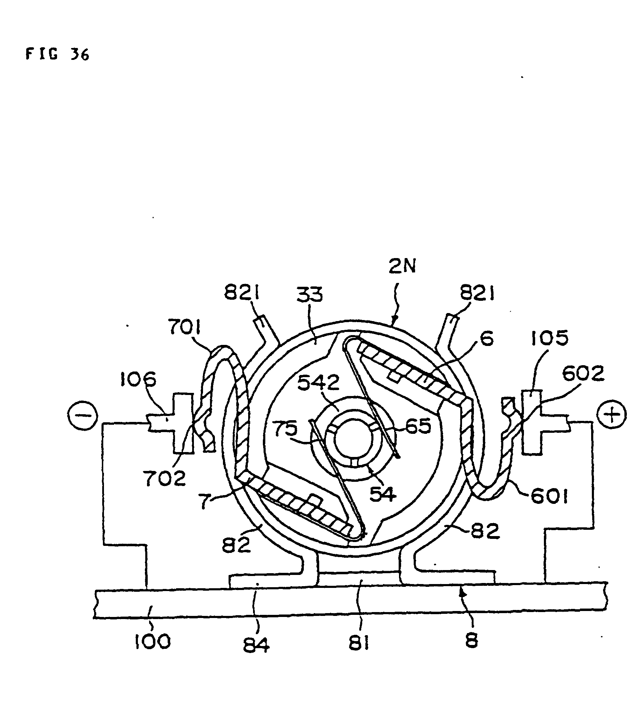

Fig. 34 is a transverse section of another embodiment of a small motor in accordance with the present invention. Fig. 35 is a side elevational view of the small motor. Fig. 36 is a transverse view of another embodiment of a small motor in accordance with the present invention.

A description will now be given of the embodiments illustrated in these figures, with the same descriptions as those of the previous embodiments being omitted. For description purposes, in Fig. 35, the left side indicates the front end, while the right side indicates the rear end.

The small motor 2M of Figs. 34 and 35 differs from the small motor 2A and the other small motors described above in the rear end structure. More specifically, a pair of openings 313 are formed in the rear end portion of the body 31 so as to oppose each other on both sides of the axial line thereof. The plus terminal 6 and the minus terminal 7 are exposed to the outside from the side face of the casing 3 through the openings 313.

A pair of contactors (power supplying portions) 103 and 104 are raised on the substrate 100. The contactors 103 and 104 are connected to the plus side and the minus side (ground) of the power supplying circuit on the substrate 100, respectively.

When the small motor 2M is mounted to the supporting member 8, the contactors 103 and 104 press against and contact the exposed portions of the plus terminal 6 and the minus terminal 7, whereby electrical conduction is achieved to allow electrical power to be supplied to the small motor 2M.

As with the small motor 2M, in the small motor 2N of Fig. 36, portions of the plus terminal 6 and the minus terminal 7 protrude from the side face of the casing 3. The protruding portions of the plus terminal 6 and minus terminal 7 are formed by elastically deformable U-shaped leaf springs 601 and 701, respectively.

When the small motor 2N is mounted to the supporting member 8, contacts 602 and 702 of the leaf springs 601 and 701, respectively, press against and contact contactors (power supplying portions) 105 and 106 connected respectively to the plus side and minus side (ground) of the power supplying circuit on the substrate 100, whereby electrical conduction is achieved to permit electrical power to be supplied to the small motor 2H.

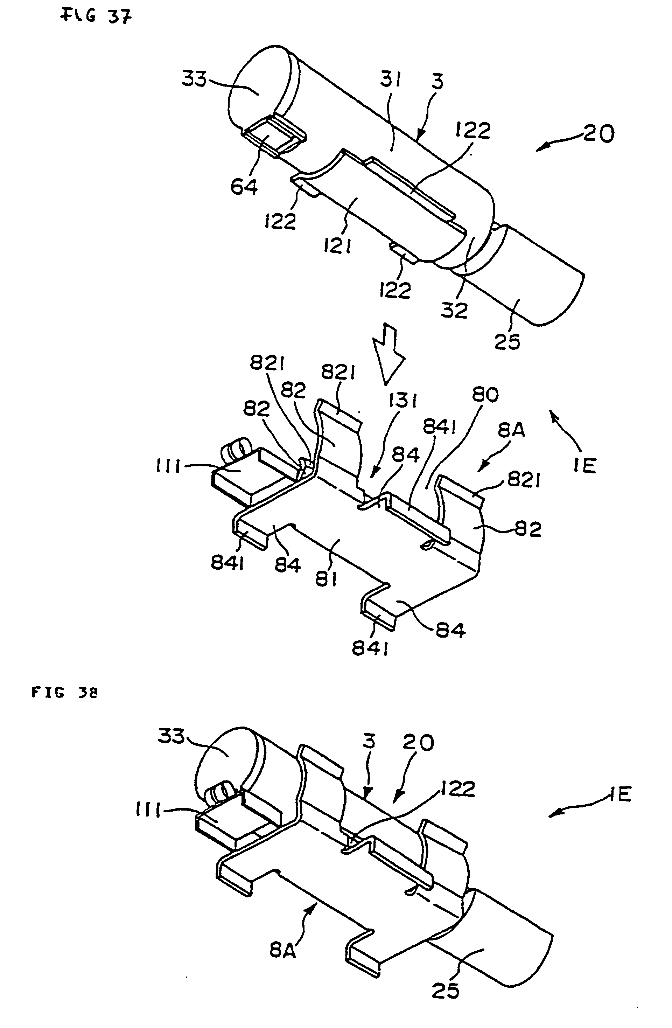

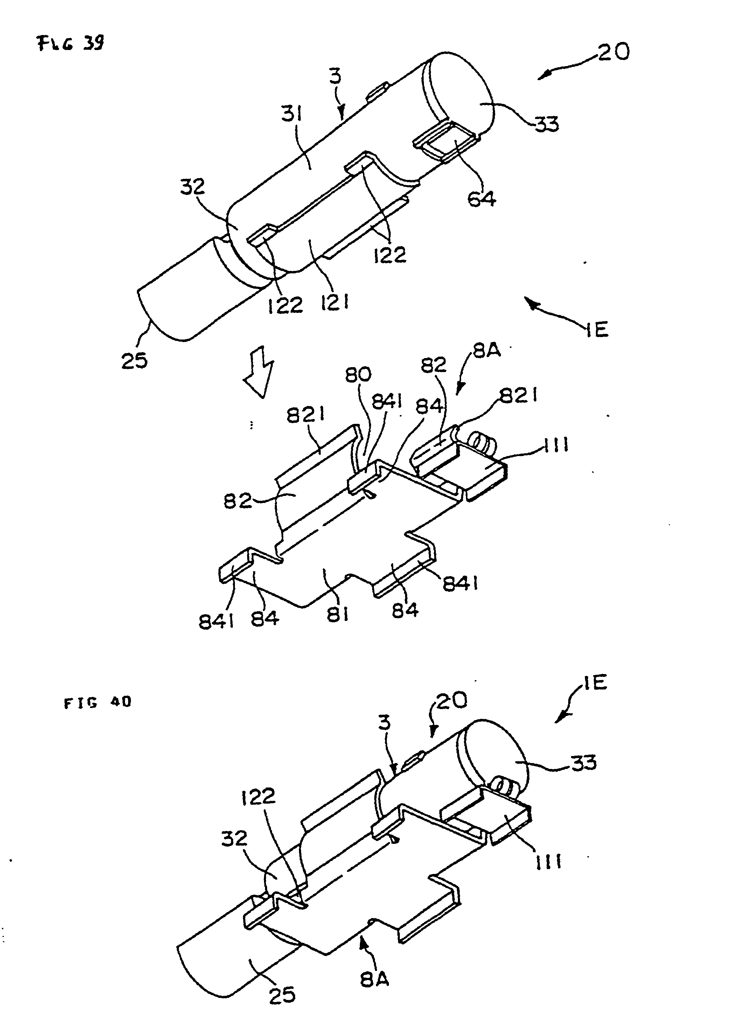

Fig. 37 is an exploded perspective view of another embodiment of a motor drive apparatus with a small motor in accordance with the present invention (with the small motor in an unmounted state). Fig. 38 is a perspective view of the motor drive apparatus (with the small motor in a mounted state). Fig. 39 is an exploded perspective view of the motor drive apparatus (with the small motor in the unmounted state). Fig. 40 is a perspective view of the motor drive apparatus (with the small motor in the mounted state).

A description will now be given of the embodiment, with the same descriptions as those of the previous embodiments being omitted. For description purposes, in Figs. 37 and 38, the right side indicates the front end, while the left side indicates the rear end. In Figs. 39 and 40, the left side indicates the front end, while the right side indicates the rear end.

As shown in the figures, the motor drive apparatus 1E of the present invention includes a substrate (not shown), like the one in the foregoing description, having formed thereon a power supplying circuit for supplying electrical power to the small motor 20, a supporting member 8A fixed to the substrate, and a small motor 20 mountable to and dismountable from the supporting member 8A.

The small motor 2O of the present embodiment is a direct-current vibrating motor and includes primarily a casing 3, a stator 4, a rotor 5, a power supplying plus terminal 6, a power supplying minus terminal 7, and a weight (eccentric mass) 25.

The internal structure of the small motor 2O is the same as that of the above-described small motor 2E of Figs. 15 and 16.

It is to be noted that in the present invention, the small motor 2O may also incorporate at least part of the structure of any one of the small motors other than the above-described small motor 2E.

The casing 3 includes a metallic (conductive) body 31, a front bracket 32 and a rear bracket 33 provided on both ends of the body 31, and a bearing 34 fixed to the center of the front bracket 32.

A plate member 121 with protruding portions 122 is fixed to the bottom (in Fig. 37) of the body 31. The protruding portions 122 are engaging portions which engage recesses 131 of the supporting member 8A to be described later.

Here, the protruding portions 122 are asymmetrically formed on the left and right sides in Fig 37 with respect to the axial line of the rotary shaft 53. In the present embodiment, one protruding portion 122 is formed on one end, and two of them are formed on the other end.

The plate member 121 can be fixed to the body 31 by, for example, soldering, brazing, bonding, or the like.

The supporting member 8A includes a bottom 81, clamping portions 82, and fixing portions 84, all of which are essentially the same as those in the foregoing description.

Recesses 131, which engages the protruding portions 122 when the small motor 2O is mounted to the supporting member 8A, is formed in the clamping portions 82 of the supporting member 8A.

The protruding portions 122 of the small motor 2O and the recesses 131 of the supporting member 8A are primary components which serve as reversed insertion preventing means (which prevent mounting of an improperly oriented small motor to the supporting member 8A, so that it allows mounting only when the small motor is properly oriented), positioning means, and anti-rotation means.

Each fixing portion 84 of the supporting member 8A has a bent portion 841 formed by bending part of each fixing portion 84 towards the substrate (towards the bottom in Fig. 37).

The supporting member 8A of the motor drive apparatus 1E is fixed at each of the fixing portions 84 to the substrate (not shown), preferably by brazing (soldering), such that electrical conduction with ground (minus terminal side) in the power supplying circuit on the substrate is achieved. This connects the minus terminal 7 of the small motor 2O to ground in the power supplying circuit on the substrate via the body 31 of the casing 3 and the supporting member 8A supporting the body 31.

A contactor (power supplying portion) 111 with a metallic contact is provided around the rear end portion of the supporting member 8A on the substrate. The contactor 111 is connected to the plus side of the power supplying circuit on the substrate.

When the small motor 2O is mounted to the supporting member 8A, the contact portion 64 of the plus terminal 6, which is exposed to the outside from the rearward outer periphery of the small motor 2O, contacts the contactor 111 to achieve electrical conduction. Therefore, the plus terminal 6 of the small motor 2O is connected to the plus side of the power supplying circuit on the substrate through the contactor 111.

By virtue of such a construction, when the small motor 2O is mounted to the supporting member 8A, it is supported by and fixed to the supporting member 8A, and, at the same time, the plus terminal 6 and the minus terminal 7 are connected to their predetermined terminals of the power supplying circuit on the circuit, respectively, thus allowing electrical power to be supplied to the small motor 2O

In the motor drive apparatus 1E, during mounting of the small motor 2O to the supporting member 8A, the reversed insertion preventing means, namely the protruding portions 122 of the small motor 2O and the recesses 131 of the supporting member 8A, engage each other to prevent reversed insertion of the small motor 2O to the supporting member 8A (that is, for example, when the small motor 2O is rotated about 180 degrees from the proper position, or when the small motor 2O has its front and back sides reversed). Therefore, the small motor 2O in a properly oriented state is mounted to the supporting member 8A. More specifically, the small motor 2O is mounted to the supporting member 8A only when the protruding portions 122 of the small motor 2O engage the recesses 131, thereby, for example, preventing the occurrence of shorted power supplying circuits or contact failures.

When an attempt is made to mount the small motor 2O to the supporting member 8A with the top and bottom sides or the front and back sides (in Fig. 37) of the small motor 2O reversed, the protruding portions bump into the clamping portions 82, so that the small motor 2O cannot be mounted, indicating that the small motor 2O is improperly oriented for mounting.

The positioning means, namely the protruding portions 122 of the small motor 2O and the recesses 131, engage each other to position the small motor 2O with respect to the supporting member 8A in the axial direction of the rotary shaft 53.

The anti-rotation means, namely the protruding portions 122 of the small motor 2O and the recesses 131, engage each other to prevent rotation of the entire small motor 2O, when driven, with respect to the supporting member 8A.

In the small motor 2O of the above-described construction, the plus terminal 6 does not protrude from the rear end of the casing 3, as has been the case with the above-described small motor 2A, but is exposed to the outside from the side face of the casing 3. Therefore, compared to the small motor 2A, the motor 2O can have a smaller overall length, and be set in a space with a smaller size in the direction of the motor length.

In the present invention, the protruding portions 122 can be formed, for example, by cutting a portion of the casing 3 and bending the cut portion, in addition to being formed in the above-described fashion.

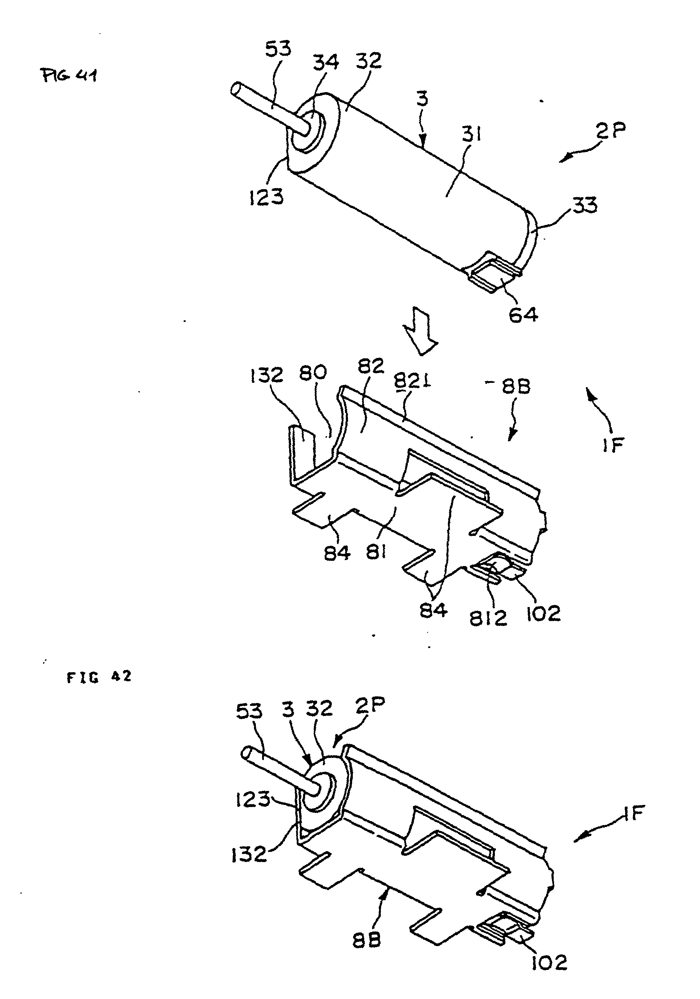

Fig. 41 is an exploded perspective view of another embodiment of a motor drive apparatus with a small motor in accordance with the present invention (with the small motor in an unmounted state). Fig. 42 is a perspective view of the motor drive apparatus (with the small motor in a mounted state).

A description will now be given of the embodiment, with the same descriptions as those of the previous embodiments being omitted. For description purposes, in Figs. 41 and 42, the left side indicates the front end, while the right side indicates the rear end.

As shown in the figures, the motor drive apparatus 1F of the present invention includes a substrate (not shown), like the one in the foregoing description, having formed thereon a power supplying circuit for supplying electrical power to the small motor 2P, a supporting member 8B fixed to the substrate, and a small motor 2P which can be mounted to and dismounted from the supporting member 8B.

The small motor 2P of the present embodiment is a direct-current vibrating motor and includes primarily a casing 3, a stator 4, a rotor 5, a power supplying plus terminal 6, a power supplying minus terminal 7, and a weight (eccentric mass) which is not shown, all of which are similar to those of the foregoing description.

The internal structure of the small motor 2P is the same as that of the small motor 2E of Figs. 15 and 16.

It is to be noted that in the present invention, the small motor 2P may also incorporate at least part of the structure of any one of the small motors other than the above-described small motor 2E.

The casing 3 includes a metallic (conductive) body 31, a front bracket 32 and a rear bracket 33 provided on both ends of the body 31, and a bearing 34 fixed to the center of the front bracket 32.

A flat cut portion 123 is formed on the left side portion (in Fig. 41) of the outer peripheral side face of the front bracket 32. The cut portion 123 is an engaging portion which engages an engager 132 of the supporting member 8B to be described later.

Forming the cut portion 123 in the front bracket 32 causes the shape of the front bracket 32 (or external shape of the small motor 2P) to be asymmetrical on the left and right sides (in Fig. 41) with respect to the axial line of the rotary shaft 53.

The supporting member 8B has a bottom 81, clamping portions 82, and fixing portions 84, all of which are essentially the same as those of the foregoing description.

The plate-shaped engager 132 is raised from the left side (in Fig. 41) of the front end portion of the bottom 81. The engager 132 opposes the clamping portion 82, with a motor mounting space 80 formed therebetween, and extends substantially at right angles to the bottom 81.

The cut portion 123 of the small motor 2P and the engager 132 of the supporting member 8B are primary components serving as reversed insertion preventing means (which prevent mounting of an improperly oriented small motor to the supporting member 8B, so that it allows mounting only when the small motor is properly oriented), positioning means, and anti-rotation means.

The supporting member 8B of the motor drive apparatus 1F is fixed at each fixing portion 84 to the substrate (not shown), preferably by brazing (soldering), such that electrical conduction is achieved with ground (minus terminal side) of the power supplying circuit on the substrate. This connects the minus terminal 7 of the small motor 2P to ground of the power supplying circuit on the substrate via the body 31 of the casing 3 and the supporting member 8B which supports the body 31.

A contactor (power supplying portion) 102 with a metallic contact is provided around the rear end portion of the supporting member 8B on the substrate. The contactor 102 is connected to the plus side of the power supplying circuit on the substrate.

When the small motor 2P is mounted to the supporting member 8B, a contactor 64 of the plus terminal 6, which is exposed to the outside from the rearward outer peripheral face of the small motor 2P, contacts the contactor 102 to achieve electrical conduction. Therefore, the plus terminal 6 of the small motor 2P is connected to the plus side of the power supplying circuit on the substrate via the contactor 102.

By virtue of such a construction, when the small motor 2P is mounted to the supporting member 8B, it is supported by and fixed to the supporting member 8B, and, at the same time, the plus terminal 6 and the minus terminal 7 are also connected to their predetermined terminals of the power supplying circuit on the substrate, thereby allowing electrical power to be supplied to the small motor 2P.

In the motor drive apparatus 1F, during mounting of the small motor 2P to the supporting member 8B, the reversed insertion preventing means, namely the cut portion 123 of the small motor 2P and the engager 132 of the supporting member 8B, engage each other to prevent reversed insertion of the small motor 2P to the supporting member 8B (such as when the small motor 2P is rotated about 180 degrees from the proper position, or when it has its front and back sides reversed). Therefore, the small motor 2P in a properly oriented state is mounted to the supporting member 8B. More specifically, the small motor 2P can be mounted to the supporting member 8B only when the cut portion 123 of the small motor 2P engages the engager 132, thereby preventing, for example, the occurrence of a shorted power supplying circuit or contact failure.

When an attempt is made to mount the small motor 2P to the supporting member 8B, with the top and bottom sides (in Fig. 41) of the small motor 2P reversed, the opposite side of the cut portion 123 of the forward bracket bumps into the engager 132, which prevents the mounting of the small motor 2P. In addition, when an attempt is made to mount the small motor 2P to the supporting member 8B, with the front and back sides of the small motor 2P reversed, the rear bracket 33 bumps into the engager 132, which also prevents the mounting of the small motor 2P. These indicate that the small motor 2P is not properly oriented for mounting.

The positioning means, namely the cut portion 123 of the small motor 2P and the engager 132, engage each other to position the small motor 2P with respect to the supporting member 8B in the axial direction of the rotary shaft 53.

The anti-rotation means, namely the cut portion 123 of the small motor 2O and the engager 132, engage each other to prevent rotation of the entire small motor 2P, when it is driven, with respect to the supporting member 8B.

In the small motor 2P with the above-described construction, the plus terminal 6 does not protrude from the rear end of the casing 3, as with the small motor 2A, but is exposed to the outside from the side face of the casing 3. Therefore, compared to the small motor 2A, the small motor 2P has a smaller overall length, and can be set in a space with a smaller size in the direction of the motor length.

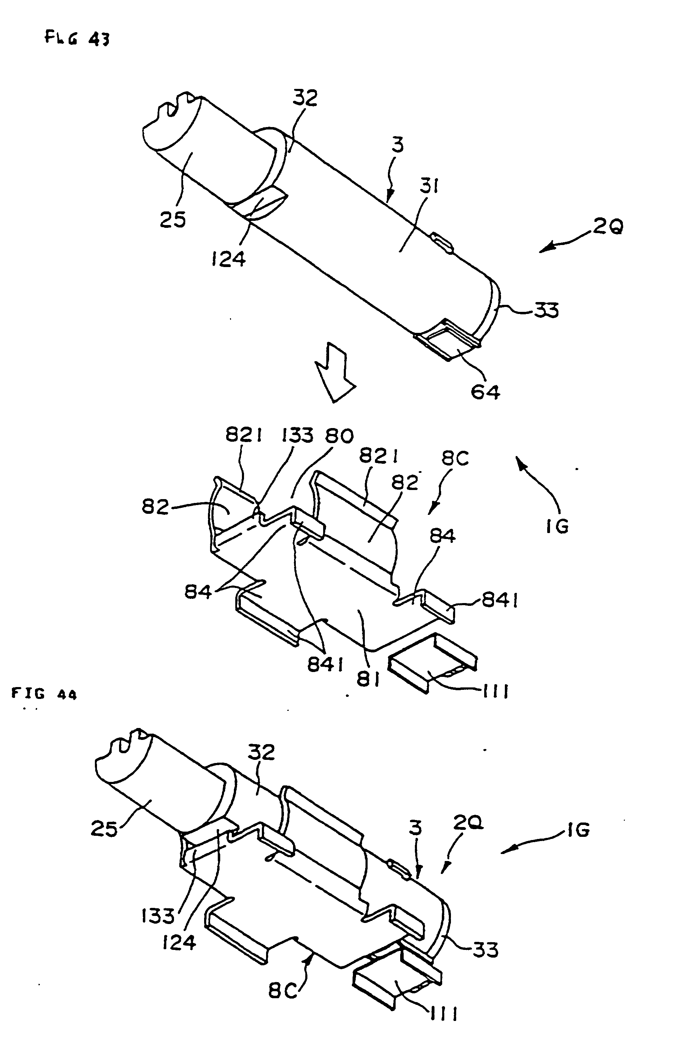

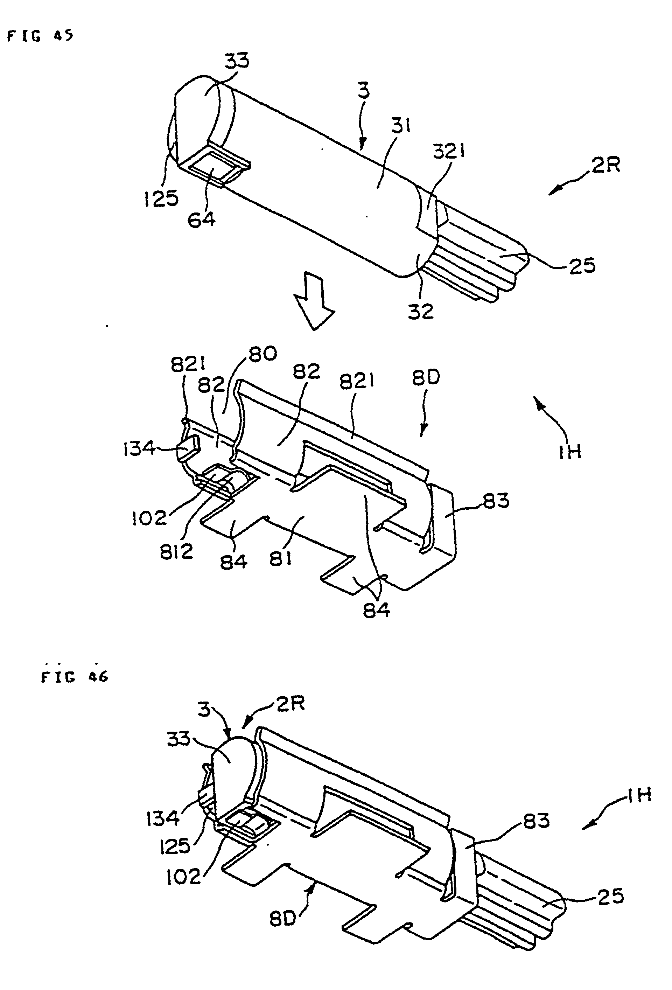

Fig. 43 is an exploded perspective view of another embodiment of a motor drive apparatus with a small motor in accordance with the present invention (with the small motor in an unmounted state). Fig. 44 is a perspective view of the motor drive apparatus (with the small motor in a mounted state).

A description will now be given of the embodiment, with the same descriptions as those of the previous embodiments being omitted. For description purposes, in Figs. 43 and 44, the left side indicates the front end, while the right side indicates the rear end.

As shown in the figures, the motor drive apparatus 1G of the present invention includes a substrate (not shown), similar to the one in the foregoing description, having formed thereon a power supply circuit for supplying electrical power to the small motor 2Q, a supporting member 8C fixed to the substrate, and a small motor 2Q which can be mounted to and dismounted from the supporting member 8C.

The small motor 2Q of the present embodiment is a direct-current vibrating motor, and primarily comprises a casing 3, a stator 4, a rotor 5, a power supplying plus terminal 6, a power supplying minus terminal 7, and a weight (eccentric mass) 25, all of which are essentially the same as those of the foregoing description.

The internal structure of the small motor 2Q is the same as that of the small motor 2E of Figs. 15 and 16.

It is to be noted that in the present invention, the small motor 2Q may incorporate at least part of any one of the other small motor other than the above-described small motor 2E.

The casing 3 includes a metallic (conductive) body 31, a front bracket 32 and a rear bracket 33 provided on both ends of the body 31, and a bearing 34 fixed to the center of the front bracket 32.

A flat-faced notch (recess) 124 is formed at the bottom (in Fig. 43) of the outer peripheral side face of the front bracket 32. The notch 124 is an engaging portion which engages an engager 133 of the supporting member 8C.

Forming the notch 124 in the front bracket 32 causes the shape of the front bracket 32 to become asymmetrical on the top and bottom sides (in Fig. 43) with respect to the axial line of the rotary shaft 53.

The supporting member 8C includes a bottom 81, clamping portions 82, and fixing portions 84, all of which are essentially the same as those of the foregoing description.

A plate-shaped engager 133 is raised from the front end of the bottom 81, and extends substantially at right angles with respect to the bottom 81.

The notch 124 of the small motor 2Q and the engager 133 of the supporting member 8C are primary components serving as reversed insertion preventing means (which prevent mounting of an improperly oriented small motor, so that it allows mounting only when the small motor is oriented properly with respect to the supporting member), the positioning means, and the anti-rotation means.

A bent portion 841 is formed on each fixing portion 84 of the supporting member 8C by bending part of each fixing portion 84 toward the substrate (or downward in Fig. 43).

The supporting member 8C of the motor drive apparatus 1G is fixed at each fixing portion 84 to the substrate (not shown), preferably by brazing (soldering), such that electrical conduction is achieved with ground (minus terminal side) of the power supplying circuit on the substrate. This connects the minus terminal 7 of the small motor 2Q to the ground of the power supplying circuit on the substrate via the body 31 of the casing 3 and the supporting member 8C which supports the body 31.

A contactor (power supplying portion) 111 with a metallic contact is provided around the rear end portion of the supporting member 8C on the substrate. The contactor 111 is connected to the plus side of the power supplying circuit on the substrate.

When the small motor 2Q is mounted to the supporting member 8C, a contactor 64 of the plus terminal 6, which is exposed to the outside from the rearward outer peripheral face of the small motor 2Q, contacts the contactor 111 to achieve electrical conduction. Therefore, the plus terminal 6 of the small motor 2Q is connected to the plus side of the power supplying circuit on the substrate via the contactor 11.

By virtue of such a construction, when the small motor 2Q is mounted to the supporting member 8C, it is supported by and fixed to the supporting member 8C, and, at the same time, the plus terminal 6 and the minus terminal 7 are also connected to their predetermined terminals of the power supplying circuit on the substrate, thus allowing electrical power to be supplied to the small motor 2Q.

In the motor drive apparatus 1G, when the small motor 2Q is mounted to the supporting member 8C, the reversed insertion means, namely the notch 124 of the small motor 2Q and the engager 133 of the supporting member 8C engage each other to prevent reversed insertion of the small motor 2Q to the supporting member 8C (such as when the small motor 2Q is rotated about 180 degrees from the proper position, or when its front and back sides are reversed). Therefore, the small motor 2Q in a properly oriented state is mounted to the supporting member 8C. More specifically, the small motor 2Q can be mounted to the supporting member 8C only when the notch 124 of the small motor 2Q engages the engager 133, thereby, for example, preventing the occurrence of a shorted power supplying circuit or contact failure.

When an attempt is made to mount the small motor 2Q to the supporting member 8C, with the top and bottom sides (in Fig. 43) of the small motor 2Q reversed, the opposite side of the notch 123 bumps into the engager 133, so that the small motor 2Q cannot be mounted. In addition, when an attempt is made to mount the small motor 2Q to the supporting member 8C, with the front and back sides of the small motor 2Q reversed, the rear bracket 33 bumps into the engager 133, so that the small motor 2Q cannot be mounted. These indicate that the small motor 2Q is not properly oriented for mounting.

The positioning means, namely the notch 124 of the small motor 2Q and the engager 133, engage each other to position the small motor 2Q with respect to the supporting member 8C in the direction of the axial line of the rotary shaft 53.

The anti-rotation means, namely the notch 124 of the small motor 2Q and the engager 133, engage each other to prevent rotation of the entire small motor 2Q, when it is driven, with respect to the supporting member 8C.

In the small motor 2Q with the above-described construction, the plus terminal 6 does not protrude from the rear end of the casing, as has been the case with the small motor 2A, but is exposed to the outside from the side face of the casing 3. Therefore, compared to the small motor 2A, it has a small overall length, and can be set a space with a smaller size in the direction of the motor length.

Fig. 45 is an exploded perspective view of another embodiment of a motor drive apparatus with a small motor in accordance with the present invention (with the small motor in an unmounted state). Fig. 46 is a perspective view of the motor drive apparatus (with the small motor in a mounted state).

A description will now be given of the embodiment, with the same descriptions as those of the previous embodiments being omitted. For description purposes, in Figs. 45 and 46, the right side indicates the front end, while the left side indicates the rear end.

As shown in the figures, the motor drive apparatus 1H of the present invention includes a substrate (not shown), similar to the one of the foregoing description, having formed thereon a power supplying circuit for supplying electrical power to the small motor 2R, a supporting member 8D fixed to the substrate, and a small motor 2R which can be mounted to and dismounted from the supporting member 8D.

The small motor 2R of the present embodiment is a direct-current vibrating motor primarily including a casing 3, a stator 4, a rotor 5, a power supplying plus terminal 6, a power supplying minus terminal 7, and a weight (eccentric mass) 25, all of which are essentially the same as those in the foregoing description.

The internal structure of the small motor 2R is the same as that of the small motor 2E of Figs. 15 and 16.

It is to be noted that in the present invention, the small motor 2R may also incorporate at least part of the structure of any one of the small motors other than the above-described small motor 2E.

The casing 3 includes a metallic (conductive) body 31, a front bracket 32 and a rear bracket 33 provided at both ends of the body 31, and a bearing 34 fixed to the center of the front bracket 32.

Flat-faced opposing notches 321, formed on both sides of the axial line of the rotor shaft 53, are formed in the outer periphery of the front bracket 32. As mentioned above, the notches 321 are engaging portions which engage engagers 83 of the supporting member 8D to be described below. The notches 321 and the engagers 83 serve as anti-rotation means for preventing rotation of the entire small motor 2R.

A flat-faced notch 125 is formed on the left side (in Fig. 45) of the outer peripheral face of the rear bracket 33. The notch 125 is an engaging portion which engages an engager 134 of the supporting member 8D to be described later.

Formation of the notch 125 on the rear bracket 33 causes the shape of the rear bracket (external shape of the small motor 2R) to become asymmetrical on the left and right sides (in Fig. 45) with respect to the axial line of the rotary shaft 53.

The notch 125 extends over the entire vertical length (in Fig. 45) in the direction in which the small motor 2R is mounted and dismounted, so that the mounting and dismounting of the small motor 2R can be performed smoothly, when the motor 2R is properly oriented.

The supporting member 8D includes a bottom 81, clamping portions 82, engaging portions 83, and fixing portions 84, all of which are essentially the same as those of the foregoing description.

A left plate-shaped engager 134 is raised from the center of the rear end of the clamping portion 82 in Fig. 45. The engager 134 extends almost at right angles toward the center of a motor mounting space 80.

The notch 125 of the small motor 2R, and the engager 134 of the supporting member 8D are primary components which serve as reversed insertion preventing means (which prevent mounting of the small motor when the small motor is not properly oriented, so that it allows mounting only when the small motor is properly oriented with respect to the supporting member), and positioning means.

The notches 321 of the small motor 2R and the engagers 83 of the supporting member 8D are primary components which serve as positioning means and anti-rotation means.

The supporting member 8D of the motor drive apparatus 1H is fixed at each fixing portion 84 to the substrate (not shown), preferably by brazing (soldering), such that electrical conduction is achieved with ground (minus terminal side) of the power supplying circuit on the substrate. This connects the minus terminal 7 of the small motor 2P to ground of the power supplying circuit on the substrate via the body 31 of the casing 3 and the supporting member 8D which supports the body 31.

A metallic contactor (power supplying portion) 102 is provided around the rear end portion of the supporting member 8D on the substrate. The contactor 102 is connected to the plus side of the power supplying circuit on the substrate.

When the small motor 2R is mounted to the supporting member 8D, a contact portion 64 of the plus terminal 6, which is exposed to the outside from the rearward outer peripheral face of the small motor 2R, contacts a contactor 102 to achieve electrical conduction. Accordingly, the plus terminal 6 of the small motor 2R is connected to the plus side of the power supplying circuit on the substrate through the contactor 102.

By virtue of such a construction, when the small motor 2R is mounted to the supporting member 8D, the small motor 2R is supported by and fixed to the supporting member 8D, and, at the same time, the plus terminal 6 and the minus terminal 7 are connected to their predetermined terminals of the power supplying circuit on the substrate to allow electrical power to be supplied to the small motor 2R.

In the motor drive apparatus 1H, when the small motor 2R is mounted to the supporting member 8B, reversed insertion preventing means, namely the notch 125 of the small motor 2R and the engager 134 of the supporting member 8D, engage each other to prevent reversed insertion of the small motor 2R into the supporting member 8D (such as when the small motor 2R is rotated about 180 degrees from its proper position, or when the front and back sides of the small motor 2R is reversed). Therefore, the small motor 2R in a properly oriented state is mounted to the supporting member 8D. More specifically, the small motor 2R can only be mounted to the supporting member 8D only when the notch 125 of the small motor 2R engages the engager 134, thereby preventing, for example, the occurrence of a shorted power supplying circuit or contact failure.

When an attempt is made to mount the small motor 2R to the supporting member 8D, with the top and bottom sides (in Fig. 45) of the small motor 2R reversed, the opposite side of the notch 125 of the rear bracket 33 bumps into the engager 134, so that the small motor 2R cannot be mounted. In addition, when an attempt is made to mount the small motor 2R to the supporting member 8D, with the front and back sides of the small motor 2R reversed, the notches 321 bump into the engager 134, and the rear bracket 33 bumps into the engagers 83, so that the small motor 2R cannot be mounted. These indicate that the small motor 2R is not oriented properly for mounting.

The positioning means, namely the notch 125 of the small motor 2R and the engager 134, and the notches 321 of the small motor 2R and the engagers 83, engage each other to position the small motor 2R with respect to the supporting member 8D in the axial direction of the rotary shaft 53.

The anti-rotation means, namely the notches 321 of the small motor 2R and the engagers 83, engage each other to prevent rotation of the entire small motor 2R, when it is driven, with respect to the supporting member 8D.

In the small motor 2R with such a construction, the plus terminal 6 does not protrude from the rear end of the casing, as with the small motor 2A, but is exposed to the outside from the side face of the casing 3. Therefore, compared to the small motor 2A, it has a shorter overall length, and can be set in a space with a smaller size in the direction of the motor length.

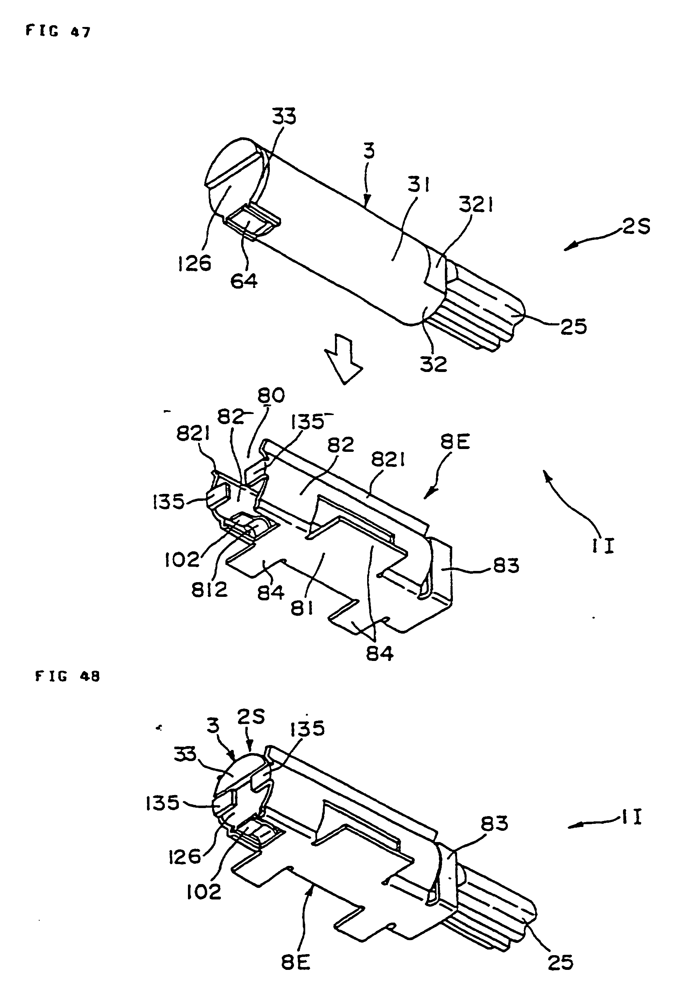

Fig. 47 is an exploded perspective view of another embodiment of a motor drive apparatus with a small motor in accordance with the present invention (with the small motor in an unmounted state). Fig. 48 is a perspective view of the motor drive apparatus (with the small motor in a mounted state).

A description will now be given of the embodiment, with the same descriptions as those of the previous embodiments being omitted. For description purposes, in Figs. 47 and 48, the right side indicates the front end, while the left side indicates the rear end.

As shown in the figures, the motor drive apparatus 1I of the present invention includes a substrate (not shown), similar to the one of the foregoing description, having formed thereon a power supplying circuit for supplying electrical power to the small motor 2S, a supporting member 8E fixed to the substrate, and a small motor 2S which can be mounted to and dismounted from the supporting member 8E.

The small motor 2S of the present embodiment is a direct-current vibrating motor, and primarily comprises a casing 3, a stator 4, a rotor 5, a power supplying plus terminal 6, a power supplying minus terminal 7, and a weight (eccentric mass) 25, all of which are essentially the same as those of the foregoing description.

The internal structure of the small motor 2S is the same as that of the small motor 2E of Figs. 15 and 16.

It is to be noted, however, that the small motor may incorporate at least part of the structure of any one of the small motors other than the small motor 2E.

The casing 3 includes a metallic (conductive) body 31, a front bracket 32 and a rear bracket 33 provided at both ends of the body 31, and a bearing 34 fixed to the center of the front bracket 32.

Flat-faced opposing notches 321, formed on both sides of the axial line of the rotary shaft 53, are formed in the outer peripheral face of the front bracket 32. The notches 321 are engaging portions which engage engagers 83 of the supporting member 8E to be described later. The notches 321 and the engagers 83 serve as anti-rotation means for preventing rotation of the entire small motor 2C.

A flat-faced notch 126 is formed in the lower side (in Fig. 47) of the outer peripheral face of the rear bracket 33. The notch 126 is an engaging portion which engages an engager 135 of the supporting member 8E to be described later.

Providing the notch 126 in the rear bracket 33 causes the shape of the rear bracket to be asymmetrical on the top and bottom sides with respect to the axial line of the rotary shaft 53.

The supporting member 8E includes a bottom 81, clamping portions 82, engagers 83, and fixing portions 84, all of which are essentially the same as those in the foregoing description.

Plate-shaped engagers 135 are raised from the center of the rear ends of the pair of clamping portions 82. The engagers 135 extend substantially at right angles to and from the rear ends towards the center of a motor mounting space 80.

The notch 126 of the small motor 2S and the engagers 135 of the supporting member 8E are primary components serving as reversed insertion preventing means (which prevent mounting of an improperly oriented small motor to the supporting member, so that they allows mounting only when the small motor is properly oriented), positioning means, and anti-rotation means.

The notches 321 of the small motor 2S and the engagers 83 of the supporting member 8E are primary components serving as positioning means and anti-rotation means.

The supporting member 8E of the motor drive apparatus 1I is fixed at each fixing portion 84, preferably by brazing (soldering), to the substrate (not shown), such that electrical conduction is achieved with ground (minus terminal side) of the power supplying circuit on the substrate. This connects the minus terminal 7 of the small motor 2S to ground of the power supplying circuit on the substrate through the body 31 of the casing 3 and the supporting member 8E which supports the body 31.

A metallic contactor (power supplying portion) 102 is formed around the rear end portion of the supporting member 8E on the substrate. The contactor 102 is connected to the plus side of the power supplying circuit on the substrate.

When the small motor 2S is mounted to the supporting member 8E, a contact portion 64 of the plus terminal 6, which is exposed to the outside from the rearward outer peripheral face of the small motor 2S, contacts the contactor 102 to achieve electrical conduction. Accordingly, the plus terminal 6 of the small motor 2S is connected to the plus side of the power supplying circuit on the substrate through the contactor 102.

By virtue of such a construction, when the small motor 2S is mounted to the supporting member 8E, the small motor 2S is supported by and fixed to the supporting member 8E, and, at the same time, the plus terminal 6 and the minus terminal 7 are connected to their predetermined terminals of the power supplying circuit on the substrate to permit electrical power supply.

In the motor drive apparatus 1I, when the small motor 2S is mounted to the supporting member 8E, the reversed insertion preventing means, namely the notch 126 of the small motor 2S and the engagers 135 of the supporting member 8E, engage each other to prevent reversed insertion of the small motor 2S to the supporting member 8E (such as when the small motor 2S is rotated about 180 degrees from the proper position, or when the front and back sides of the motor 2S are reversed), so that the small motor 2S in a properly oriented state is mounted to the supporting member 8E. In other words, the small motor 2S can be mounted to the supporting member 8E only when the notch 126 of the small motor 2S engages the engagers 135, thus preventing, for example, the occurrence of a shorted power supplying circuit or contact failure.

When an attempt is made to mount the small motor 2S to the supporting member 8E, with the top and bottom sides (in Fig. 47) of the small motor 2S reversed, the opposite side of the notch 126 of the rear bracket 33 bumps into the engagers 135, so that the motor 2S cannot be mounted. In addition, when an attempt is made to mount the small motor 2S to the supporting member 8E, with the front and back sides of the small motor 2S reversed, the front bracket 32 bumps into the engagers 135, and the rear bracket 33 bumps into the engagers 83, so that the motor 2S cannot be mounted. These indicate that the small motor 2S is improperly oriented for mounting.

The positioning means, namely the notch 126 of the small motor 2S and the engagers 135, and the notches 321 of the small motor 2S and the engagers 83, engage each other to position the small motor 2S with respect to the supporting member in the axial line direction of the rotary shaft 53.

The anti-rotation means, namely the notch 126 of the small motor 2S and the engagers 135, and the notches 321 of the small motor 2S and the engagers 83, engage each other to prevent rotation of the entire small motor 2S, when it is driven, with respect to the supporting member 8E.

In the small motor 2S with the above-described construction, the plus terminal 6 does not protrude from the rear end of the casing 3, as has been the case with the small motor 2A, but is exposed to the outside from the side face of the casing 3. Therefore, compared to the small motor 2A, it can have a smaller overall length, and be set in a space with a smaller size in the direction of the motor length.

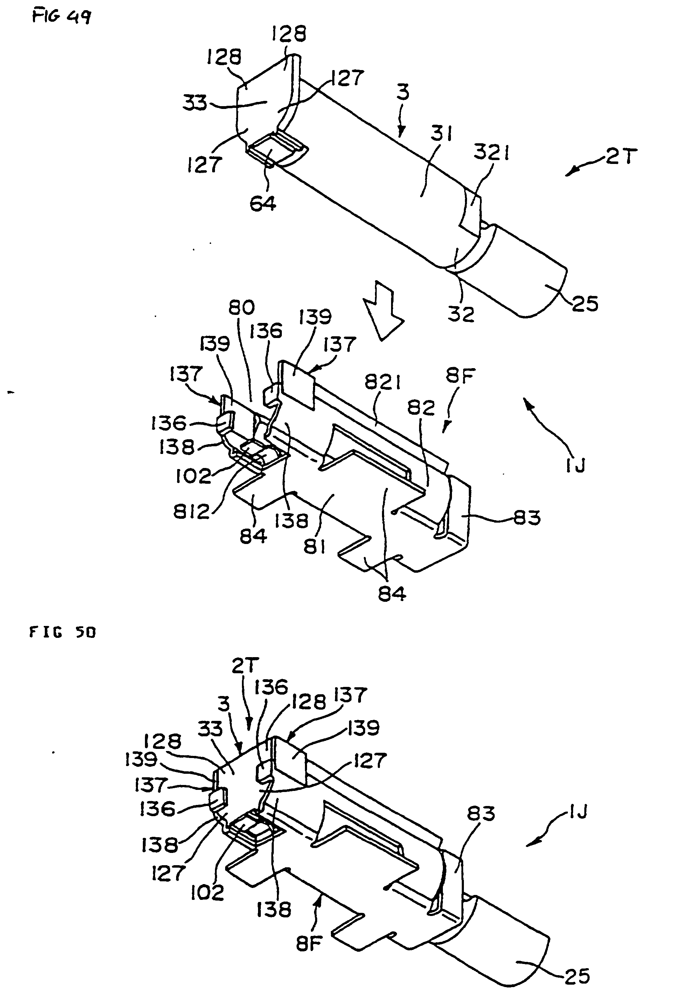

Fig. 49 is an exploded perspective view of another embodiment of a motor drive apparatus with a small motor in accordance with the present invention (with the small motor in an unmounted state). Fig. 50 is a perspective view of the motor drive apparatus (with the small motor in a mounted state).

A description will now be given of the embodiment, with the same descriptions as those of the previous embodiments being omitted. For description purposes, in Figs. 49 and 50, the right side indicates the front end, while the left side indicates the rear end.

As shown in the figures, the motor drive apparatus 1J of the present invention includes a substrate (not shown), similar to the one in the foregoing description, having formed thereon a power supplying circuit for supplying electrical power to the small motor 2T, a supporting member 8F fixed to the substrate, and a small motor 2T which can be mounted to and dismounted from the supporting member 8F.

The small motor 2T of the present embodiment is a direct-current vibrating motor, and comprises primarily a casing 3, a stator 4, a rotor 5, a power supplying plus terminal 6, a power supplying minus terminal 7, and a weight (eccentric weight) 25, all of which are essentially the same as those of the foregoing description.

The internal structure of the small motor 2T is the same as that of the small motor 2E of Figs. 15 and 16.

It is to be noted, however, that in the present invention, the small motor-2T may incorporate at least part of the structure of any of the other small motors other than the small motor 2E.

The casing 3 includes a metallic (conductive) body 31, a front bracket 32 and a rear bracket 33 provided at both ends of the body 31, and a bearing 34 fixed to the center of the front bracket 32.

Flat-faced opposing notches 321, formed on both sides of the axial line of the rotary shaft 53, are formed in the outer peripheral face of the front bracket 32. The notches 321, as in the foregoing description, are engaging portions which engage engagers 83 of the supporting member 8F to be described later. The notches 321 and the engagers 83 serve as anti-rotation means for preventing rotation of the entire small motor 2T.

The rear bracket 33 has at its outer peripheral face a pair of arcuately curved portions 127, and a pair of corners 128 extending further outward than the curved portions 127. In this case, the corners 128 are formed above (in Fig. 49) the curved portions 127, and cause the shape of the rear bracket 33 to become asymmetrical on the left and right sides with respect to the axial line of the rotary shaft 53, as shown in Fig. 49.

The rear bracket 33 is an engaging portion which engages engagers 137 of the supporting member 8F to be described later. More specifically, the curved portions 127 of the rear bracket 33 engage bases 183 of the engagers 137 to be described later, and the corners 128 engage front ends 139 of the engagers 137 to be described later.

The supporting member 8F includes a bottom 81, clamping portions 82, engagers 83, and fixing portions 84, all of which are essentially the same as those of the foregoing description.

The engagers 137 are provided on the rear ends of the pair of clamping portions 82. Each engager 137 includes arcuately curved base 138 whose shape corresponds to the shape of the curved portion 127 formed at the outer periphery of the rear bracket 33, and plate-shaped front ends 139 formed in correspondence with their respective corners 128.

The engagers 137 are spaced apart by a motor mounting space 80 so as to oppose each other, and the front end 139 of each engager 137 extends substantially at right angles to the bottom 81.

Plate-shaped engagers 136 are raised from the center of the rear ends of the engagers 137. The engagers 136 extend almost at right angles to the rear ends towards the center of the motor mounting space 80. When the small motor 2T is mounted, these engaging portions 136 contact the rear end faces of the rear bracket 33 to position the small motor 2T in the axial line direction of the rotary shaft 53.

The corners 128 of the rear bracket 33 of the small motor 2T and the engagers 137 of the supporting member 8F are primary components serving as reversed insertion preventing means (which prevent mounting of an improperly oriented small motor to the supporting member, so that it allows mounting only when the small motor is properly oriented with respect to the supporting member), and anti-rotation means.

The notches 321 of the small motor 2T and the engagers 83 of the supporting member 8F are primary components serving as positioning means and the anti-rotation means.

The rear bracket 33 of the small motor 2T and the engagers 136 of the supporting member 136 are primary components serving as positioning means.

The supporting member 8F of the motor drive apparatus IJ is fixed at each fixing portion 84, preferably by brazing (soldering), to the substrate (not shown), such that electrical conduction is achieved with ground (minus terminal side) of the power supplying circuit formed on the substrate. This connects the minus terminal 7 of the small motor 2T to ground of the power supplying circuit on the substrate through the body 31 of the casing 3 and the supporting member 8F which supports the body 31.

A metallic contactor (power supplying portion) 102 is provided around the rear end portion of the supporting member 8F on the substrate. The contactor 102 is connected to the plus side of the power supplying circuit on the substrate.

When the small motor 2T is mounted to the supporting member 8F, a contact portion 64 of the plus terminal 6, which is exposed to the outside from the rearward outer peripheral face of the small motor 2T, contacts the contactor 102 to achieve electrical conduction. Therefore, the plus terminal 6 of the small motor 2T is connected to the plus side of the power supplying circuit on the substrate through the contactor 102.

By virtue of such a construction, when the small motor 2T is mounted to the supporting member 8F, the small motor 2T is supported by and fixed to the supporting member 8F, and, at the same time, the plus terminal 6 and the minus terminal 7 are connected to their predetermined terminals of the power supplying circuit on the substrate to permit electrical power supply.

In the motor drive apparatus 1J, when the small motor 2T is being mounted to the supporting member 8F, the reversed insertion preventing means, namely the corners 128 of the rear bracket 33 of the small motor 2T and the engagers 137 of the supporting member 8F engage each other to prevent reversed insertion of the small motor 2T to the supporting member 8F (such as when the small motor 2T is rotated about 180 degrees from the proper position, or when the front and back sides of the small motor 2T is reversed). Therefore, the small motor 2T in a properly oriented state is mounted to the supporting member 8F. In other words, the small motor 2T can be mounted to the supporting member 8F only when the rear bracket 33 of the small motor 2T engages the engagers 137 (or when the curved portions 127 engage the bases 138), thus preventing, for example, the occurrence of a shorted power supplying circuit or contact failure.

When an attempt is made to mount the small motor 2T to the supporting member 8F, with the top and bottom sides (in Fig. 49) of the small motor 2T reversed, the corners 128 of the rear bracket 33 bump into the bases 138 of the engagers 137, so that the small motor 2T cannot be mounted. When an attempt is made to mount the small motor 2T to the supporting member 8F, with the front and back sides of the small motor 2T reversed, the rear bracket 33 bumps into the engagers 83, so that the small motor 2T cannot be mounted. These indicate that the small motor 2T is not properly oriented for mounting.

The positioning means, namely the rear bracket 33 of the small motor 2T and the engagers 136, and the notches 321 of the small motor 2T and the engagers 83, engage each other to position the small motor 2T with respect to the supporting member 8F in the axial line direction of the rotary shaft 53.

The anti-rotation means, namely the rear bracket 33 of the small motor 2T and the engagers 136, and the notches 321 of the small motor 2T and the engagers 83, engage each other to prevent rotation of the entire small motor 2T, when it is driven, with respect to the supporting member 8F.

In the small motor 2T having the above-described construction, the plus terminal 6 does not protrude from the rear end of the casing 3, as has been the case with the small motor 2A, but is exposed to the outside from the side face of the casing 3. Therefore, compared to the small motor 2A, it can be made smaller in overall length and can be set in a space with a smaller size in the direction of the motor length.

Although in the present invention, the corners 128 were described as being formed on the rear bracket 33, they may also be formed, for example, on the body 31 or the front bracket 32.

Although in the present embodiment, the corners 128 are symmetrical on the left and right sides in Fig. 49, they may be formed asymmetrically on the left and right sides in the present invention.

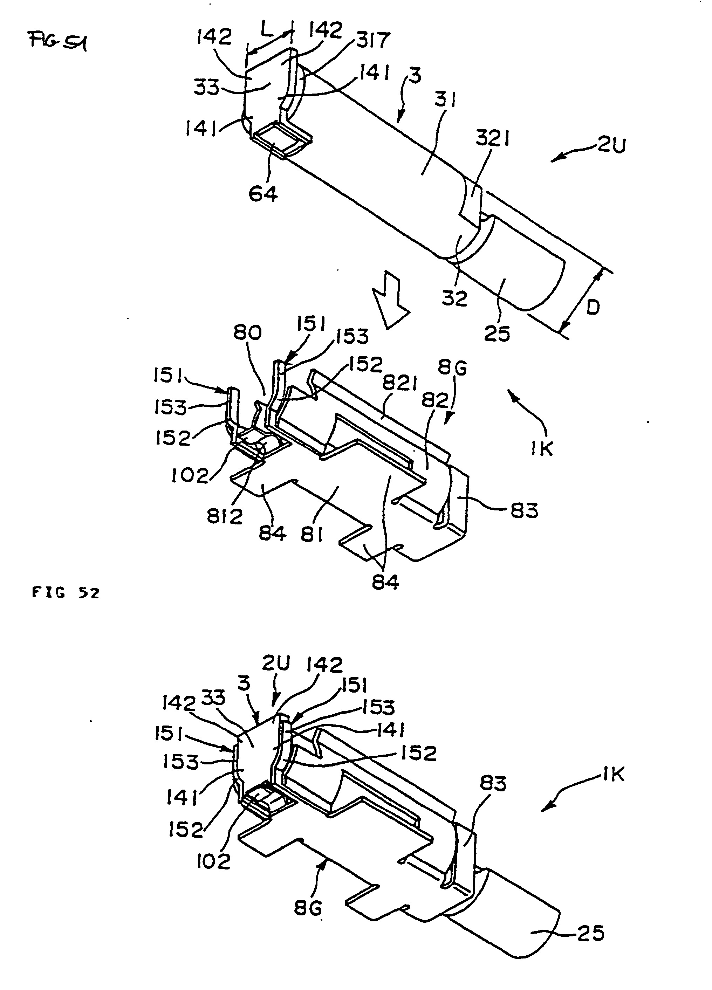

Fig. 51 is an exploded perspective view of another embodiment of a motor drive apparatus with a small motor in accordance with the present invention (with the small motor in an unmounted state). Fig. 52 is a perspective view of the motor drive apparatus (with the small motor in a mounted state).

A description will now be given of the embodiment, with the same descriptions as those of the previous embodiments being omitted. For description purposes, in Figs. 51 and 52, the right side indicates the front end, while the left side indicates the rear end.

As shown in the figures, the motor drive apparatus 1K of the present invention includes a substrate (not shown), which is similar to the one of the foregoing description, having formed thereon a power supplying circuit for supplying electrical power to the small motor 2U, a supporting member 8G fixed to the substrate, and a small motor 2U which can be mounted to and dismounted from the supporting member 8G.

The small motor 2U of the present embodiment is a direct-current vibrating motor, and includes primarily a casing 3, a stator 4, a rotor 5, a power supplying plus terminal 6, a power supplying minus terminal 7, and a weight (eccentric mass) 25.

The internal structure of the small motor 2U is the same as that of the small motor 2E of Figs. 15 and 16.

It is to be noted, however, that in the present invention, the small motor 2U may incorporate at least part of any one of the other small motors other than the above-described small motor 2E.

The casing 3 includes a metallic (conductive) body 31, a front bracket 32 and a rear bracket 33 provided at both ends of the body 31, and a bearing 34 fixed to the center of the front bracket 32.

Flat-faced opposing notches 321, formed on both sides of the axial line of the rotary shaft 53, are formed in the outer peripheral face of the front bracket 32. As in the foregoing description, the notches 321 are engaging portions which engage engagers 83 of the supporting member 8G to be described later. The notches 321 and the engagers 83 serve as anti-rotation means for preventing rotation of the entire small motor 2U.

The rear bracket 33 has at its outer periphery a pair of arcuately curved portions 141, and a pair of corners 142 extending further outward than the curved portions 141. In this case, the corners 142 are located above (in Fig. 51) of the curved portions 141, and cause the shape of the rear bracket 33 to become asymmetrical on the top and bottom sides (in Fig. 51) with respect to the axial line of the rotary shaft 53.

The width of the rear bracket 33 (or the width between the corners 142 of the casing 3) L is smaller than the outer diameter D of the body 31 of the casing 3. This causes part of a rear end face 317 of the body 31 to be exposed to the outside. When the small motor 2U is mounted, the exposed part contacts engagers 151 of the supporting member 8G to be described later in order to position the small motor 2U in the axial line direction of the rotary shaft 53.

In order to prevent insertion with the front and back sides of the small motor 2U reversed, it is preferable that the width L of the rear bracket 33 be larger than the distance between the inner faces of the opposing engagers 83.

Such a rear bracket 33 is an engaging portion which engages engagers 151 of the supporting member 8G to be described later. More specifically, the curved portions 141 of the rear bracket 33 engage intermediate portions 152 of the engagers 151 to be described later, and the corners 142 engage front ends 153 of the engagers 151.

The supporting member 8G includes a bottom 81, clamping portions 82, engaging portions 83, and fixing portions 84, all of which are essentially the same as those of the foregoing description.

The engagers 151 are provided at the rear end of each clamping portion 82. Each of the engagers 151 has arcuately-curved intermediate portions 152, which are formed at the outer peripheral face of the rear bracket 33 in correspondence with the shape of the curved portions 141, and the plate-shaped front ends 153, formed in correspondence with the corners 142.

The engagers 151, separated apart by a motor mounting space 80, oppose each other, and the front end 153 of each engager 151 extends substantially at right angles to the bottom 81.

The corners 142 of the rear bracket 33 of the small motor 2U and the engagers 151 of the supporting member 8G are primary components serving as reversed insertion preventing means (which prevent mounting of the small motor to the supporting member when the motor is not properly oriented, so that it allows mounting only when the small motor is properly oriented), and anti-rotation means.

The notches 321 of the small motor 2U and the engagers 83 of the supporting member 8G are primary components serving as positioning means and anti-rotation means.

The rear end face 317 of the body 31 of the small motor 2U and the engagers 151-are primary components serving as positioning means.

The supporting member 8G of the motor drive apparatus 1K is fixed at each fixing portion 84, preferably by brazing (soldering), to the substrate (not shown), such that electrical conduction is achieved with ground (minus terminal side) of the power supplying circuit formed on the substrate. This connects the minus terminal 7 of the small motor 2U to ground of the power supplying circuit on the substrate through the body 31 of the casing 3 and the supporting member 8G which supports the body 31.

A metallic contactor (power supplying portion) 102 is provided around the rear end portion of the supporting member 8G on the substrate. The contactor 102 is connected to the plus side of the power supplying circuit on the substrate.

When the small motor 2U is mounted to the supporting member 8G, a contact portion 64 of the plus terminal 6, which is exposed to the outside from the rearward outer peripheral face of the small motor 2U, contacts the contactor 102 to achieve electrical conduction.

By virtue of such a construction, when the small motor 2U is mounted to the supporting member 8G, the small motor 2U is supported by and fixed to the supporting member 8G, and, at the same time, the plus terminal 6 and the minus terminal 7 are connected to their predetermined terminals of the power supplying circuit on the substrate to allow electrical power supply.

In the motor drive apparatus 1K, when the small motor 2U is being mounted to the supporting member 8G, the reversed insertion prevention means, namely the corners 142 of the rear bracket 33 of the small motor 2U and the engagers 151 of the supporting member 8G, engage each other to prevent reversed insertion of the small motor 2U to the supporting member 8G (such as when the small motor 2U is rotated about 180 degrees from the proper position, or when the front and back sides of the small motor 2U are reversed). Therefore, the small motor in a properly oriented state is mounted to the supporting member 8G. More specifically, the small motor 2U can be mounted to the supporting member 8G only when the rear bracket 33 of the small motor 2U engages the engagers 151 (that is the curved portions 141 engage the intermediate portions 152). This prevents, for example, the occurrence of a shorted power supplying circuit or contact failure.

When an attempt is made to mount the small motor 2U to the supporting member 8, with the top and bottom sides (in Fig. 51) of the small motor 2U reversed, the corners 142 of the rear bracket 33 bump into the intermediate portions 152 of the engagers 151, so that the motor 2U cannot be mounted. When an attempt is made to mount the small motor 2U to the supporting member, with the front and back sides of the small motor 2U reversed, the rear bracket 33 bumps into the engagers 83, so that the motor 2U cannot be mounted. These indicate that the small motor 2U is not properly oriented for mounting.

The positioning means, namely the rear end face 317 of the body 31 of the small motor 2U and the engagers 151, and the notches 321 of the small motor 2U and the engagers 83 engage each other to position the small motor 2U to the supporting member 8G in the axial line direction of the rotary shaft 53.

The anti-rotation means, namely the rear bracket 33 of the small motor 2U and the engagers 151, and the notches 321 of the small motor 2U and the engagers 83, engage each other to prevent rotation of the entire small motor 2U, when it is driven, with respect to the supporting member 8G.

In the motor drive apparatus 1K having the above-described construction, the small motor 2U can be clamped, without having to provide engagers 136, by engagement of the rear end face 317 of the body 31 and the engagers 151, and engagement of the notches 321 and the engagers 83. That is, the small motor 2U can be positioned in the axial line direction of the rotary shaft 53 in the aforementioned way, thereby simplifying its structure as compared to that of the motor drive apparatus 1J.

In the small motor 2U with such a construction, the plus terminal 6 does not protrude from the rear end of the casing 3, as has been the case with the small motor 2A, but is exposed to the outside from the side face of the casing 3. Therefore, compared to the small motor 2A, it can have a small overall length, and be set in a space with a smaller size in the direction of the motor length.

Although the corners 142 were described as being formed on the rear bracket 33, they may, for example, be formed on the front bracket 32.

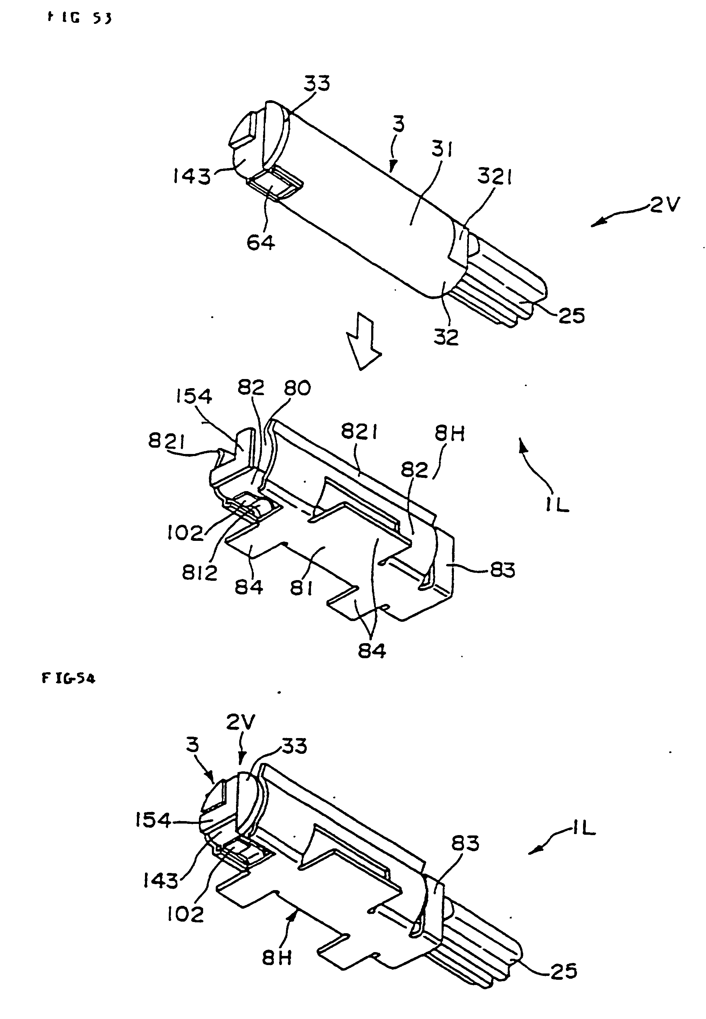

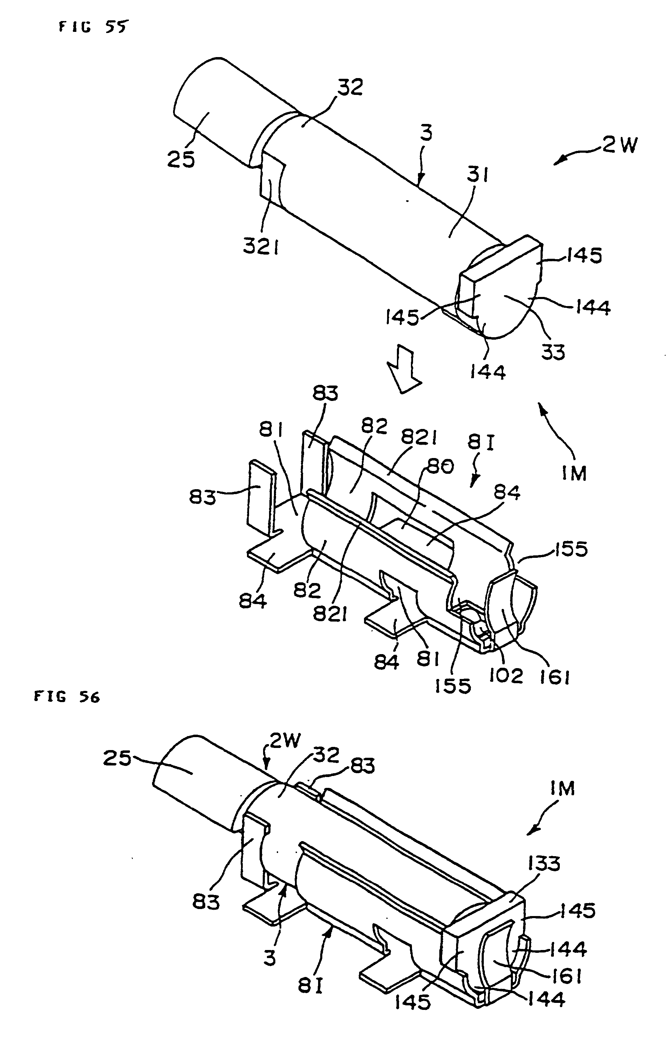

Fig. 53 is an exploded perspective view of another embodiment of a motor drive apparatus with a small motor in accordance with the present invention (with the small motor in an unmounted state). Fig. 54 is a perspective view of the motor drive apparatus (with the small motor in a mounted state).

A description will now be given of the embodiment, with the same descriptions as those of the previous embodiments being omitted. For description purposes, in Figs. 53 and 54, the right side indicates the front end, while the left side indicates the rear end.

As shown in the figures, the motor drive apparatus 1L of the present invention includes a substrate (not shown), which is similar to the one of the foregoing description, having formed thereon a power supplying circuit for supplying electrical power to the small motor 2V, a supporting member 8H fixed to the substrate, and a small motor 2V which can be mounted to and dismounted from the supporting member 8H.

The small motor 2V of the present embodiment is a direct-current vibrating motor, and comprises primarily a casing 3, a stator 4, a rotor 5, a power supplying plus terminal 6, a power supplying minus terminal 7, and a weight (eccentric mass) 25, all of which are essentially the same as those of the foregoing description.

The internal structure of the small motor 2V is the same as that of the small motor 2E of Figs. 15 and 16.

It is to be noted, however, that in the present invention the small motor 2V may incorporate at least part of the structure of any one of the small motors other than the small motor 2E.

The casing 3 includes a metallic (conductive) body 31, a front bracket 32 and a rear bracket 33 provided on both ends of the body 31, and a bearing 34 fixed to the center of the front bracket 32.

Flat-faced opposing notches 321, disposed on both sides of the axial line of a rotary shaft 53, are formed in the outer peripheral face of the front bracket 32. As in the foregoing description, the notches 321 are engaging portions which engage engagers 83 of the supporting member 8H to be described later, and serve as anti-rotation means for preventing rotation of the entire small motor 2V.

A recess 143 is formed in the rear end face of the rear bracket 33. The recess 143 is an engaging portion which engages an engager 154 of the supporting member 8H to be described later.

The recess extends across the entire vertical length (in Fig. 53) in the direction and mounting and dismounting of the small motor 2V. Therefore, the mounting and dismounting of the small motor 2V in a properly oriented state can be smoothly performed.

The supporting member 8H includes a bottom 81, clamping portions 82, engaging portions 83, and fixing portions 84, all of which are essentially the same as those of the foregoing description.

An L-shaped engager is raised from the center of the rear end of the left clamping portion 82 (in Fig. 53). The engager 154 extends substantially at right angles to the rear end towards the center of a motor mounting space 80.

The recess 143 of the small motor 2V and the engager 154 of the supporting member 8H are primary components serving as reversed insertion preventing means (which prevent mounting of an improperly oriented small motor to the supporting member, so that small motor 2V can be mounted only when it is properly oriented), positioning means, and anti-rotation means.

The notches 321 of the small motor 2V and the engagers 83 of the supporting member 8H are primary component parts serving as positioning means and anti-rotation means.

The supporting member 8H of the motor drive apparatus 1L is fixed at each fixing portion 84, preferably by brazing (soldering), to the substrate (not shown), such that electrical conduction is achieved with ground (minus terminal side) of the power supplying circuit on the substrate. This connects the minus terminal 7 of the small motor 2V to ground of the power supplying circuit on the substrate through the body 31 of the casing 3 and the supporting member 8H which supports the body 31.

A metallic contactor (power supplying portion) 102 is provided around the rear end portion of the supporting member 8H on the substrate. The contactor 102 is connected to the plus side of the power supplying circuit on the substrate.

When the small motor 2V is mounted to the supporting member 8H, a contact portion 64 of the plus terminal, which is exposed to the outside from the rearward outer peripheral face of the small motor 2V, contacts the contactor 102 to achieve electrical conduction. Therefore, the plus terminal 6 of the small motor 2V is connected to the plus side of the power supplying circuit on the substrate through the contactor 102.

By virtue of such a construction, when the small motor 2V is mounted to the supporting member 8H, the small motor 2V is supported by and fixed to the supporting member 8H, and, at the same time, the plus terminal 6 and the minus terminal 7 are connected to their predetermined terminals on the power supplying circuit on the substrate to permit electrical power to the small motor 2V.

In the motor drive apparatus 1L, when the small motor 2V is being mounted to the supporting member 8H, the reversed insertion preventing means, namely the recess 143 of the small motor 2V and the engager 154 of the supporting member 8H, engage each other to prevent reversed insertion of the small motor 2V to the supporting member 8H (such as when the small motor 2V is rotated about 180 degrees from the proper position, or when the front and back sides of the small motor 2V are reversed). Therefore, the small motor 2V in a properly oriented state is mounted to the supporting member 8H. More specifically, the small motor 2V can be mounted to the supporting member 8H only when the recess 143 of the small motor 2V engages the engager 154, thus making it possible to, for example, prevent the occurrence of a shorted power supplying circuit or contact failure.

When an attempt is made to mount the small motor 2V to the supporting member 8H, with the top and bottom sides (in Fig. 53) of the small motor 2V reversed, the rear bracket 33 bumps into the engager 154, so that the small motor 2V cannot be mounted. When an attempt is made to mount the small motor 2V to the supporting member 8H, with the front and back sides of the small motor 2V reversed, the rear bracket 33 bumps into the engager 83, and the front bracket 32 bumps into the engager 154, so that the small motor 2V cannot be mounted. These indicate that the small motor 2V is not properly oriented for mounting.

The positioning means, namely the recess 143 of the small motor 2V and the engager 154, and the notches 321 of the small motor 2V and the engager 83 engage each other to position the small motor 2V to the supporting member 8H in the axial line direction of the rotary shaft 53.

The anti-rotation means, namely the recess 143 of the small motor 2V and the engager 154, and the notches 321 of the small motor 2V and the engager 83, engage each other to prevent rotation of the entire small motor 2V, when it is driven, with respect to the supporting member 8H.

In the small motor 2V having the above-described construction, the plus terminal 6 does not protrude from the rear end of the casing 3, as has been the case with the small motor 2A, but is exposed to the outside from the side face of the casing 3. Therefore, compared to the small motor 2A, it has a smaller overall length, and can be sent in a space with a smaller size in the direction of the motor length.

Fig. 55 is an exploded perspective view of another embodiment of a motor drive apparatus with a small motor in accordance with the present invention (with the small motor in an unmounted state). Fig. 56 is a perspective view of the motor drive apparatus (with the small motor in a mounted state).

A description will now be given of the embodiment, with the same descriptions as those of the previous embodiments being omitted. For description purposes, in Figs. 55 and 56, the left side indicates the front end, while the right side indicates the rear end.

As shown in the figures, the motor drive apparatus 1M of the present invention includes a substrate, similar to the one of the foregoing description, having formed thereon a power supplying circuit for supplying electrical power to the small motor 2W, a supporting member 8I fixed to the substrate, and a small motor 2W which can be mounted to and dismounted from the supporting member 8I.

The small motor 2W of the present embodiment is a direct-current vibrating motor, and comprises primarily a casing 3, a stator 4, a rotor 5, a power supplying plus terminal 6, a power supplying minus terminal 7, and a weight (eccentric mass) 25, all of which are essentially the same as those of the foregoing description.

The internal structure of the small motor 2W is the same as that of the small motor 2E of Figs. 15 and 16.

It is to be noted, however, that in the present invention the small motor 2W may incorporate at least part of the structure of any of the small motors other than the aforementioned small motor 2E.

The casing 3 includes a metallic (conductive) body 31, a front bracket 32 and a rear bracket 33 provided at both ends of the body 31, and a bearing 34 fixed to the center of the front bracket 32.

Flat-faced opposing notches 321, formed on both sides of the axial line of a rotary shaft 53, are formed in the outer peripheral face of the front bracket 32. As in the foregoing description, the notches 321 are engaging portions which engage engagers 83 of the supporting member 8I to be described later, and serve as anti-rotation means for preventing rotation of the entire small motor 2W.

The rear bracket 33 has at is outer peripheral face a pair of arcuately curved portions 144, and a pair of corners 145 extending further outward than the curved portions 144. In this case, the corners 145 are located above (in Fig. 55) of the curved portions 144, and cause the shape of the rear bracket 33 to become asymmetrical (in Fig. 55) on the top and bottom sides with respect to the axial line of the rotary shaft 53.

The corners 145 are engaging portions which engage notches 155 of the supporting member 8I to be described later.

The supporting member 8I includes a bottom 81, clamping portions 82, engaging portions 83, and fixing portions 84, all of which are essentially the same as those of the foregoing description.

Each notch of the pair of notches 155 is formed in the upper side of the rear end of each clamping portion of the pair of clamping portions 82. An elastic portion (biasing means) 161 in the form of a leaf spring curved toward a motor mounting space 80, is provided at the rear end of the bottom 81.

When the small motor 2W is mounted, the restoring force of the elastic portion 161 pushes the rear end face of the rear bracket 33 toward the front, pushing the corners 145' of the rear bracket 33 against the ends of the clamping portions 82 as well as rear ends (stepped portions) of the notches 321 against the engagers 83. In other words, the elastic portion 161 and the clamping portions 82 reliably clamp or hold the rear bracket 33, thus preventing the small motor 2W from shaking in the direction of the axial line of the rotary shaft 53.

The corners 145 of the small motor 2W and the notches 155 of the supporting members 8I are primary components serving as reversed insertion preventing means (which prevent mounting of the small motor to the supporting member, when the small motor is not properly oriented, so that it allows mounting only when the small motor is properly oriented), positioning means, and anti-rotation means.

The notches 321 of the small motor 2W and the engagers 83 of the supporting member 8I are primary components serving as positioning means and anti-rotation means.

The supporting member 8I of the motor drive apparatus 1M is fixed at each fixing portion 84, preferably by brazing (soldering), to the substrate (not shown), such that electrical conduction is achieved with ground (minus terminal side) of the power supplying circuit on the substrate. This connects the minus terminal 7 of the small motor 2V to ground of the power supplying circuit on the substrate through the body 31 of the casing 3 and the supporting member 8I which supports the body 31.

A metallic contactor (power supplying portion) 102 is provided around the rear end portion of the supporting member 8I on the substrate. The contactor 102 is connected to the plus side of the power supplying circuit on the substrate.

When the small motor 2W is mounted to the supporting member 8I, a contact portion 64 of the terminal 6, which is exposed to the outside from the rearward outer peripheral face of the small motor 2W, contacts the contactor 102 to achieve electrical conduction. Therefore, the plus terminal 6 of the small motor 2W is connected to the plus side of the power supplying circuit on the substrate through the contactor 102.

By virtue of such a construction, when the small motor 2W is mounted to the supporting member 8I, the small motor 2W is supported by and fixed to the supporting member 81, and, at the same time, the plus terminal 6 and the minus terminal 7 are connected to their predetermined terminals on the power supplying circuit on the substrate to permit electrical power supply.

In the motor drive apparatus 1M, when the small motor 2W is being mounted to the supporting member 8I, the reversed insertion preventing means, namely the corners 145 of the small motor 2W and the notches 155 of the supporting member 8I, engage each other to prevent reversed insertion of the small motor 2W to the supporting member 8I (such as when the small motor 2W is rotated about 180 degrees from the proper position, or when the front and back sides of the small motor 2W are reversed). Therefore, the small motor 2W in a properly oriented state is mounted to the supporting member 8I. More specifically, the small motor 2W can be mounted to the supporting member 8I only when the corners 145 of the small motor 2W engage the notches 155, thus preventing, for example, the occurrence of a shorted power supplying circuit or contact failure.

When an attempt is made to mount the small motor 2W to the supporting member 8I, with the top and bottom sides (in Fig. 55) of the small motor 2W reversed, the upper side faces of the corners 145 of the rear bracket bump into the notches 155, so that the small motor 2W cannot be mounted. When an attempt is made to mount the small motor 2W to the supporting member 8I with the front and back sides of the small motor 2W reversed, the rear bracket 33 bumps into the engagers 83, and the front bracket 32 bumps into the elastic portion 161, so that the small motor 2W cannot be mounted. These indicate that the small motor 2W is not properly oriented for mounting.

The positioning means, namely the corners 145 of the small motor 2W and the notches 155, and the notches 321 of the small motor 2W and the engagers 83, engage each other to position the small motor 2W to the supporting member 8I in the direction of the axial line of the rotary shaft 53.

As described above, the biasing means, or the elastic portion 161, pushes the rear end face of the rear bracket 33 towards the front, pushing the corners 145 of the rear bracket 33 against the ends of the clamping portions 82, and the notches 321 against the engagers 83. This prevents shaking of the small motor 2W in the direction of the axial line of the rotary shaft 53.

The anti-rotation, namely the corners 145 of the small motor 2W and the notches 155, and the notches 321 of the small motor 2W and the engagers 83 engage each other to prevent rotation of the entire small motor 2W, when it is driven, with respect to the supporting member 8I.

In the present invention, biasing means, such as the aforementioned elastic portion 161, may also be provided for any one of the above-described motor drive apparatuses, in addition to the above-described motor drive apparatus 1M.

Although in the above-described small motors 2A to 2W, the size of the weight 25 (eccentric mass) 25 with respect to the casing 3 is not particularly limited, in order to produce a large vibration by eccentric rotation, it is preferable that the specific gravity of the weight 25 be made large, and that the maximum radius of rotation of the weight 25 be made as large as possible. In the present invention, it is advantageous to make the maximum radius of rotation of the weight 25 as large as possible.

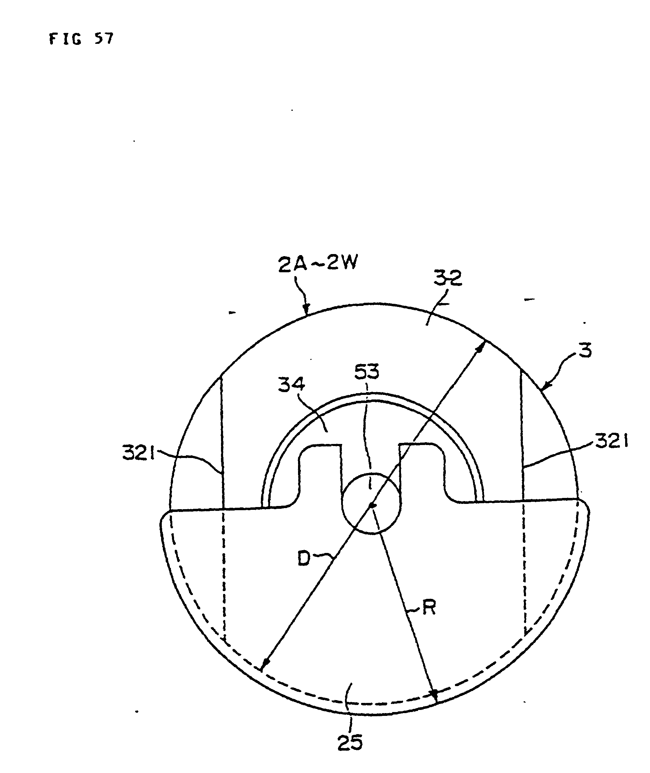

More specifically, as shown in Fig. 57, in the small motors 2A to 2W in the present invention, it is preferable that the maximum radius of rotation of the weight 25, defined as R, and the outer diameter of the casing 3, defined as D, satisfy the relationship R > D/2, and more preferably that they satisfy the relationship D > R > D/2.

This is because since the small motors 2A to 2W are supported by and fixed to the supporting members 8 to 8I, at least a gap measuring a distance corresponding to the thickness of the bottom 81 of the supporting members 8 to 8I is formed, so that the maximum rotational radius R of the weight 25 can increased by a corresponding amount. In addition, it is possible to increase the maximum rotational radius R by forming, for example, a recess, a notch, a groove, or the like (not shown) in a location of the substrate 100 in correspondence with the location of the weight 25 to prevent contact with the weight 25.

Setting the maximum rotational radius R of the weight 25 so as to satisfy the above-described relationships results in good vibration characteristics, and, in particular, a larger vibration, which improves the performance of the vibrating motor.

Although in the foregoing description, the motor drive apparatus of the present invention were described with reference to the preferred embodiments illustrated in the figures, the present invention is not limited thereto, but defined in the appended claims.

The present invention is not limited in application to a vibrating motor having a weight (eccentric mass), as with the embodiments. It can be applied to various motors which do not produce vibration, and may be applied to a brushless motor, a stepping motor, or the like.

In addition, the structure and shape of the motor, the number of poles and wiring inside and outside the motor, the shape and materials of the supporting member, are not limited to those of the embodiments, so that changes can be made in the aforementioned factors.

Further, each of the anti-rotation means, positioning means, and reversed insertion preventing means can be variously combined.

Still further, predetermined component parts with engaging portions may be constructed to serve as at least two of the anti-rotation means, positioning means, and reversed insertion preventing means.

### Industrial Applicability

The motor drive apparatus of the present invention are suited for use in apparatuses, such as a pager or a portable telephone (including personal handyphone system or PHS), or attachments thereof (designed specifically for indicating signal reception).

## Claims

1. A motor drive apparatus, comprising:
a supporting member (8) and a small motor, comprising a casing (3), mountable to and dismountable from said supporting member (8), wherein said motor drive apparatus further comprises reversed insertion preventing means for preventing mounting to said supporting member (8) when said small motor is not properly oriented or positioned,
**characterized in that**
said reversed insertion preventing means are formed by a protruding portion of said motor and a recess of said supporting member so as to be engageable only when said small motor is properly oriented or positioned for mounting to said supporting member (8), wherein said protruding portion is asymmetrical to the axial line of said small motor, and wherein a contactor (101; 102; 103; 104; 105; 106; 107) is provided at the rear end of the supporting member (8), said contactor (101; 102; 103; 104; 105; 106; 107) providing a biasing means for biasing the small motor in axial direction.

2. A motor drive apparatus according to claim 1, wherein
said reversed insertion preventing means are formed by a corner of said small motor and an engager of said supporting member (8) so as to be engageable only when said small motor is properly oriented or positioned for mounting to said supporting member (8).

3. A motor drive apparatus according to claim 2, wherein when said casing (3) has an outside diameter D and said casing (3) has a width L at said corner, the relationship L < D is satisfied.

4. A motor drive apparatus according to one of the preceding claims, including a bottom (81) and a plurality of elastically deformable clamping portions (82).

5. A motor drive apparatus according to one of the preceding claims, wherein said contactor (101; 102; 103; 104; 105; 106; 107) is a metallic leaf spring curved into a U shape.

## Patentansprüche

1. Motorantriebsvorrichtung, umfassend:
ein Halterungsteil (8) und einen Kleinmotor, der ein Gehäuse (3) umfasst, das an dem Halterungsteil (8) angebracht und davon abgenommen werden kann, wobei die Motorantriebsvorrichtung darüber hinaus Verhinderungseinrichtungen für verkehrten Einbau umfasst, um ein Anbringen am Halterungsteil (8) zu verhindern, wenn der Kleinmotor nicht ordnungsgemäß ausgerichtet oder positioniert ist,
**dadurch gekennzeichnet, dass**
die Verhinderungseinrichtungen für verkehrten Einbau aus einem vorspringenden Abschnitt des Motors und einer Ausnehmung des Halterungsteils gebildet sind, die nur dann ineinander eingreifen können, wenn der Kleinmotor zur Anbringung am Halterungsteil (8) ordnungsgemäß ausgerichtet oder positioniert ist, wobei der vorspringende Abschnitt zur Axiallinie des Kleinmotors asymmetrisch ist, und wobei ein Kontaktglied (101; 102; 103; 104; 105; 106; 107) am hinteren Ende des Halterungsteils (8) vorgesehen ist, wobei das Kontaktglied (101; 102; 103; 104; 105; 106; 107) ein Vorspannungsmittel bereitstellt, um den Kleinmotor in der Axialrichtung vorzuspannen.

2. Motorantriebsvorrichtung nach Anspruch 1, wobei die Verhinderungseinrichtungen für verkehrten Einbau durch eine Ecke des Kleinmotors und ein Eingreifglied des Halterungsteils (8) gebildet sind, die nur dann ineinander eingreifen können, wenn der Kleinmotor zur Anbringung am Halterungsteil (8) ordnungsgemäß ausgerichtet oder positioniert ist.

3. Motorantriebsvorrichtung nach Anspruch 2, wobei, wenn das Gehäuse (3) einen Außendurchmesser D und das Gehäuse (3) eine Breite L an dieser Ecke hat, das Verhältnis L < D erfüllt ist.

4. Motorantriebsvorrichtung nach einem der vorhergehenden Ansprüche, einen Boden (81) und mehrere elastisch verformbare Klemmabschnitte (82) umfassend.

5. Motorantriebsvorrichtung nach einem der vorhergehenden Ansprüche, wobei das Kontaktglied (101; 102; 103; 104; 105; 106; 107) eine U-förmig gekrümmte Metallflachfeder ist.

## Revendications

1. Appareil d'entraînement par moteur, comprenant :
un élément de support (8) et un petit moteur, comprenant un carter (3), montable sur ledit élément de support (8) et démontable de celui-ci, dans lequel ledit appareil d'entraînement par moteur comprend en outre des moyens d'empêchement d'insertion inversée pour empêcher le montage sur ledit élément de support (8) lorsque ledit petit moteur n'est pas correctement orienté ou positionné,
**caractérisé en ce que**
lesdits moyens d'empêchement d'insertion inversée sont formés par une partie en saillie dudit moteur et un retrait dudit élément de support de manière à pouvoir être mis en prise seulement lorsque ledit petit moteur est correctement orienté ou positionné pour montage sur ledit élément de support (8), dans lequel ladite partie en saillie est asymétrique par rapport à la ligne axiale dudit petit moteur, et dans lequel un contacteur (101 ; 102 ; 103 ; 104 ; 105 ; 106 ; 107) est prévu à l'extrémité arrière de l'élément de support (8), ledit contacteur (101 ; 102 ; 103 ; 104 ; 105 ; 106 ; 107) fournissant des moyens de poussée pour pousser ledit petit moteur dans la direction axiale.

2. Appareil d'entraînement par moteur selon la revendication 1, dans lequel
lesdits moyens d'empêchement d'insertion inversée sont formés par un coin dudit petit moteur et un élément de mise en prise dudit élément de support (8) de manière à pouvoir être mis en prise seulement lorsque ledit petit moteur est correctement orienté ou positionné pour montage sur ledit élément de support (8).

3. Appareil d'entraînement par moteur selon la revendication 2, dans lequel lorsque ledit carter (3) a un diamètre extérieur D et ledit carter (3) a une largeur L audit coin, la relation L < D est satisfaite.

4. Appareil d'entraînement par moteur selon l'une quelconque des revendications précédentes, comprenant un fond (81) et une pluralité de parties de serrage déformables élastiquement (82).

5. Appareil d'entraînement par moteur selon l'une quelconque des revendications précédentes, dans lequel ledit contacteur (101 ; 102 ; 103 ; 104 ; 105 ; 106 ; 107) est un ressort à lame métallique incurvé en forme de U.
